# EUROPÄISCHE PATENTSCHRIFT

(11) **EP 2 843 712 B1**
(45) Veröffentlichungstag und Bekanntmachung des Hinweises auf die Patenterteilung: **19.05.2021**
(21) Anmeldenummer: 14183172.7
(22) Anmeldetag: 02.09.2014
(51) Int. Cl.: H01L 31/18, H01L 21/67, H01L 21/304

(54) **Vorrichtung und Verfahren zur Herstellung eines Wafers mit einer selektiven Positionierung im Trägersystem**
Device and method for the manufacture of a wafer having selective positioning in the carrier system
Dispositif et procédé destinés à fabriquer un wafer doté d'un positionnement sélectif dans un système de support

(30) Priorität: 02.09.2013 DE 102013014623
(43) Veröffentlichungstag der Anmeldung: 04.03.2015
(73) Patentinhaber: Siltectra GmbH, 01099 Dresden (DE)
(72) Erfinder: Lichtensteiger, Lukas, 8037 Zürich (CH); Man, Hau-Kit, 8052 Zürich (CH); Richter, Jan, 01277 Dresden (DE)
(74) Vertreter: Westphal, Mussgnug Patentanwälte & Partner mbB

(56) Entgegenhaltungen:
- EP-A1- 2 620 408
- US-A1- 2012 234 887
- US-A1- 2012 322 227
- US-A1- 2012 322 228

## Beschreibung

Die vorliegende Erfindung bezieht sich auf ein Verfahren zur Herstellung von Festkörperschichten, auf einen gemäß dem Verfahren hergestellten Wafer und auf eine Vorrichtung zum Herstellen von Festkörperschichten.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafer für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hohes Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Bei Verwendung der Verfahren nach bisherigem Stand der Technik weisen die hergestellten Wafer üblicherweise jeweils größere Dickenschwankungen auf. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet bzw. führen die Dickenschwankungen bei der Weiterverarbeitung des Wafers zu Problemen oder Wirkungsgradeinbußen. Außerdem liegen bei den am häufigsten auftretenden Dickenverteilungsmustern die Bereiche mit den größten Schwankungen ungünstigerweise in der Mitte des Wafers, wo sie am meisten stören.

Außerdem entstehen bei den Verfahren nach aktuellem Stand der Technik insbesondere in der Nähe des Waferrandes auf der Waferoberfläche relativ ausgedehnte Bereiche mit signifikant größerer Rauheit. Dies führt dazu, dass diese Randbereiche für viele Anwendungen nicht nutzbar sind. Außerdem erschweren diese rauen Stellen die Weiterverarbeitung des ganzen Wafers und können sogar zum späteren Zerbrechen des Wafers führen.

Die US 2012 322 227 A1 beschreibt ein Verfahren zum Abtrennen einer Schicht von einem Festkörper. Das Verfahren sieht vor, eine Spannungserzeugungsschicht auf einer Oberfläche und entlang von Seitenflächen des Festkörpers herzustellen. Auf der Spannungserzeugungsschicht wird zunächst eine Platte, wie beispielsweise eine Metallplatte oder ein Halbleiterwafer aufgebracht, die ein spontanes Abplatzen einer Schicht von dem Festkörper unter dem Einfluss der Spannungserzeugungsschicht verhindert. Diese Platte wird anschließend kontrolliert von der Spannungserzeugungsschicht geschoben, um ein kontrolliertes Ablösen der Schicht vo dem Festkörper zu erreichen.

Es ist Aufgabe der vorliegenden Erfindung ein Verfahren und eine Vorrichtung zur Herstellung von Festkörperschichten und/oder Festkörperplatten bereitzustellen, welche/s die Qualität der hergestellten Festkörperschichten bzw. Festkörperplatten gegenüber den bekannten Verfahren verbessert, insbesondere soll die Rauheit in den Festkörperrandbereichen verringert und/oder eine gleichmäßigere Schichtdicke der gesamten Festkörperschichten und/oder Festkörperplatten erzeugt werden.

Diese zuvor genannte Aufgabe wird durch ein Verfahren zur Herstellung von Festkörperschichten und/oder Platten, insbesondere zur Verwendung als Wafer, gemäß Anspruch 1 gelöst.

Die Grundidee der vorliegenden Erfindung ist es somit, den Bruch zum Ablösen der Festkörperschicht über eine wesentlich größere Fläche als das eigentliche Werkstück laufen zu lassen, und das Werkstück innerhalb dieser größeren Bruchfläche an einer Stelle zu positionieren, wo mit den erwähnten Methoden zur Beeinflussung der Bruchpropagation reproduzierbar möglichst geringe Dickenschwankungen erzielt werden können. Damit dies möglich ist, muss neben einer genügend guten Reproduzierbarkeit der Bruchpropagation und der daraus folgenden Verteilungen der Dickenschwankungen insbesondere auch gewährleistet sein, dass ein Bruch "von außerhalb" des Werkstücks in das Werkstück hineinlaufen kann, ohne so stark gestört zu werden, dass größere zusätzliche Dickenschwankungen erzeugt werden. Es wurde experimentell festgestellt, dass dies bei geeigneten Anordnungen tatsächlich möglich ist, so dass die Dickenschwankungen auch an den Rändern des Werkstücks relativ gering bleiben.

Mit der vorliegenden Erfindung, d.h. insbesondere durch die Verwendung einer Kombination von das Werkstück überlagernden und von an das Werkstück angrenzenden, eine Ablöseschicht beinhaltenden Schichtsystemen, zur Erzeugung insbesondere thermisch induzierter mechanischer Spannungsfelder und zum Ablösen einer Festkörperschicht entlang einer sich innerhalb des Werkstücks erstreckenden Ebene von dem Werkstück, werden alle zuvor genannten Probleme und Einschränkungen behoben. Als Werkstück wird in den hier beschriebenen Anwendungsbeispielen vorzugsweise ein dickerer Wafer verwendet, von welchem dann unter Verwendung des beschriebenen Verfahrens ein oder mehrere, dünnere Wafer abgespaltet werden.

Diese Lösung ist vorteilhaft, da sie ermöglicht die Qualität der hergestellten Wafer gegenüber den bekannten Verfahren zu verbessern, insbesondere die Rauheit in den Waferrandbereichen zu verringern und eine gleichmäßigere Schichtdicke des gesamten Wafers zu erzeugen, indem die zu spaltende dickere Scheibe innerhalb eines größeren Schichtsystems an einer geeigneten Position platziert wird und der Abspaltvorgang über das gesamte Schichtsystem hinweg geeignet geführt wird, insbesondere unter Verwendung einer Ablöseschicht, die an den Scheibenrand angrenzt, sich beim Abspaltvorgang kontrolliert ablöst oder spaltet und den Abspaltvorgang in die dickere Scheibe "weiterleitet", wodurch der Abspaltvorgang in der Scheibe selbst besser kontrollierbar wird.

Die erfindungsgemäße Lösung ist ferner vorteilhaft, da erstmalig eine Rissführung ermöglicht wird, die nicht ausschließlich durch die Eigenschaften des Werkstücks beeinflusst wird, sondern ebenfalls durch die Eigenschaften einer oder mehrerer Schichten, die zumindest abschnittsweise um das Werkstück herum angeordnet sind, wodurch die sich ergebenden Dickenschwankungen deutlich reduziert werden können.

Das erfindungsgemäße Verfahren weist die folgenden Schritte auf: Zumindest abschnittsweises Überlagern der Aufnahmeschicht durch eine Ablöseschicht, wobei die Ablöseschicht bevorzugt zumindest abschnittsweise eine oder mehrere erste Grenzflächen mit der Aufnahmeschicht bildet, Verbinden der Aufnahmeschicht mit der exponierten Oberfläche des Werkstücks unter Bildung einer Kompositstruktur bzw. eines Laminats, wobei die Aufnahmeschicht bevorzugt zumindest abschnittsweise eine zweite Grenzfläche mit der exponierten Oberfläche des Werkstücks bildet, wobei diese zweite Grenzfläche bevorzugt durch einen Rand begrenzt wird, welcher zumindest abschnittsweise im Wesentlichen an einen Rand einer oder mindestens einer der einen oder mehreren ersten Grenzflächen angrenzt, und wobei bevorzugt die eine oder mindestens eine der einen oder mehreren ersten Grenzflächen und die zweite Grenzfläche zumindest abschnittsweise im Wesentlichen zueinander parallel ausgerichtet sind.

Die im Schichtsystem verwendeten Schichten bestehen z.B. aus Polymer, insbesondere aus PDMS, und/oder anderen Materialien, wobei die Aufnahmeschicht bevorzugt aus Polymer, insbesondere PDMS, besteht und wobei die an den Rand der dickeren Scheibe angrenzende Ablöseschicht bevorzugt ein sprödes Material, bevorzugt ein Material mit einer Reißfestigkeit, die sich um weniger als eine Größenordnung von der Reißfestigkeit des Materials des Werkstücks bzw. der dickeren Scheibe unterscheidet, umfasst, oder alternativ die Ablöseschicht zu einer weiteren Schicht eine Grenzfläche bildet, so dass die Reißfestigkeit dieser Grenzfläche zumindest abschnittsweise kleiner als oder gleich groß wie die Reißfestigkeit des Materials der dickeren Scheibe ist. Mit den beschriebenen erfindungsgemäßen Verfahren können Festkörperschichten, wie insbesondere Wafer, mit viel geringeren totalen Dickenschwankungen hergestellt werden (Wafer mit Dickenschwankungen < 40% der mittleren Waferdicke wurden so bereits experimentell verifiziert), wobei insbesondere auch die Rauheit in den Waferrandbereichen verringert werden kann.

Als Polymer kann z.B. ein Polydiorganolsiloxan verwendet werden, z.B. Polydimethylsiloxane (PDMS). Im Folgenden wird als Polymerschicht bzw. als Aufnahmeschicht eine Folie aus PDMS und als Werkstück ein Wafer, insbesondere ein dicker Wafer, aus Germanium beschrieben; es können aber auch andere geeignete Polymere und Werkstücke (z.B. aus anderen Materialien, wie Galliumarsenid, Silizium, Galliumnitrid, Siliziumcarbid, Saphir, etc.) verwendet werden.

Weitere vorteilhafte Ausgestaltungen der Erfindung sind Gegenstand der Unteransprüche.

Erfindungsgemäß breitet sich bei der Beaufschlagung der Kompositstruktur mit dem Spannungsfeld ein Riss zum Ablösen der Festkörperschicht zunächst innerhalb der Ablöseschicht derart aus, dass ein Teil der Ablöseschicht abgespalten wird.

Gemäß dieser Ausführungsform wird somit zumindest zeitweise und bevorzugt stets zeitgleich mit oder zeitlich kurz vor, bevorzugt weniger als eine Sekunde vor dem Ablösen der Festkörperschicht vom Werkstück zumindest abschnittsweise entlang einer sich innerhalb der Ablöseschicht erstreckenden Ebene von der Ablöseschicht eine dünnere Schicht abgelöst, bevorzugt in Abschnitten, wo ein Rand mindestens einer der einen oder mehreren ersten Grenzflächen zumindest abschnittsweise im Wesentlichen an einen Rand der zweiten Grenzfläche angrenzt, wobei die Abschnitte der sich innerhalb der Ablöseschicht erstreckenden Ebene, entlang welcher die dünnere Schicht von der Ablöseschicht abgelöst wird, zumindest abschnittsweise bevorzugt parallel zu und weiter bevorzugt im Wesentlichen in derselben Ebene liegen, wie die sich innerhalb des Werkstücks erstreckende Ebene, von der die Festkörperschicht abgelöst wird. Die Aufnahmeschicht und die Ablöseschicht bestehen in dieser bevorzugten Ausführungsform der Erfindung bevorzugt aus unterschiedlichen Materialien, wobei die Aufnahmeschicht bevorzugt ein Polymer, insbesondere Polydimethylsiloxane (PDMS), aufweist und die Ablöseschicht bevorzugt ein sprödes Material, bevorzugt ein Material mit einer Reißfestigkeit, die sich um weniger als eine Größenordnung von der Reißfestigkeit des Materials des Werkstücks unterscheidet, umfasst. Bevorzugt wird in dieser Ausführungsform der vorliegenden Erfindung die Geometrie der einen oder mehreren ersten Grenzflächen so gewählt, dass substantiell entlang des gesamten Rands der zweiten Grenzfläche eine oder mehrere der einen oder mehreren ersten Grenzflächen angrenzen, so dass die zweite Grenzfläche im Wesentlichen an ihrem gesamten Rand von ersten Grenzflächen umgeben ist.

Weiterhin ist denkbar, dass das Werkstück zwei exponierte Oberflächen, welche im Wesentlichen zueinander parallel orientiert sind und auf einander gegenüberliegenden Seiten des Werkstücks liegen aufweist, wobei das Werkstück bevorzugt eine Platte oder Scheibe ist, wobei die Aufnahmeschicht unter Bildung einer Kompositstruktur bzw. eines Laminats mit der einen der beiden einander gegenüberliegenden exponierten Oberflächen des Werkstücks verbunden wird, wobei die zweite der beiden einander gegenüberliegenden exponierten Oberflächen des Werkstücks mit einer Stabilisierungsschicht verbunden wird. Bevorzugt wird diese Stabilisierungsschicht in Bereichen, wo sie nicht mit der zweiten exponierten Oberfläche des Werkstücks verbunden ist, zumindest abschnittsweise durch die Ablöseschicht und die Aufnahmeschicht überlagert, wobei die Stabilisierungsschicht zumindest abschnittsweise eine oder mehrere dritte Grenzflächen mit der Ablöseschicht bildet, wobei bevorzugt mindestens eine dieser eine oder mehrere dritte Grenzflächen zumindest abschnittsweise durch zumindest eine der eine oder mehrere erste Grenzflächen zwischen Ablöseschicht und Aufnahmeschicht überlagert wird, wobei bevorzugt Stabilisierungsschicht, Ablöseschicht und Aufnahmeschicht zumindest abschnittsweise im Wesentlichen jeweils zueinander parallel sind. Die Stabilisierungsschicht weist bevorzugt ein Polymer, insbesondere Polydimethylsiloxane (PDMS), auf. Gemäß einer bevorzugten Ausführungsform besteht die Stabilisierungsschicht aus zwei oder mehreren Einzelschichten, welche unter Bildung einer Kompositstruktur bzw. eines Laminats miteinander verbunden sind, wobei bevorzugt mindestens eine dieser Einzelschichten aus einem Material besteht, dessen E-Modul im Wesentlichen, genau oder mindestens doppelt so groß ist, wie der E-Modul des Materials mindestens einer der anderen dieser Einzelschichten. Zum Beispiel besteht die Stabilisierungsschicht bevorzugt aus einer PDMS-Schicht, welche bevorzugt zwischen 0.01 und 10mm dick ist und welche mit einer Aluminiumschicht, welche bevorzugt dicker als 0.1mm ist, verbunden ist, wobei die PDMS-Schicht mit der zweiten der beiden einander gegenüberliegenden exponierten Oberflächen des Werkstücks verbunden ist.

Die Ablöseschicht wird erfindungsgemäß derart in Umfangsrichtung des Werkstücks ausgebildet, insbesondere in einem Abstand von weniger als 10 mm bevorzugt von weniger als 5 mm und besonders bevorzugt von weniger als 2 mm zu dem Werkstück, dass der Rissverlauf in der Ablöseschicht und in dem Werkstück zumindest im Wesentlichen in derselben Ebene liegt.

Der Riss springt bevorzugt von der Ablöseschicht auf das Werkstück über, wobei der Rissverlauf aus der Ablöseschicht auf das Werkstück derart übertragen wird, dass nur eine geringe Dickenschwankung auftritt.

Durch die Ablöseschicht wird gemäß einer weiteren bevorzugten Ausführungsform der vorliegenden Erfindung ein Rahmen ausgebildet, der das Werkstück zumindest in Umfangsrichtung vollständig umschließt.

Gemäß dieser Ausführungsform kann somit die erste Grenzfläche beispielsweise als Scheibe gewählt werden, in deren Innern eine flächige Aussparung existiert, welche genau der Form der zweiten Grenzfläche entspricht und leicht, bevorzugt weniger als einen Millimeter, größer als diese ist, so dass beim Verbinden von Aufnahme- und Ablöseschicht mit der exponierten Oberfläche des Werkstücks die zweite Grenzfläche im Wesentlichen innerhalb eines Rahmens zu liegen kommt, welcher durch den Rand der Aussparung in der ersten Grenzfläche gebildet wird, wobei der Rand der Aussparung im Wesentlichen entlang seiner gesamten Länge an den Rand der zweiten Grenzfläche angrenzt.

Beispielsweise kann als Ablöseschicht ein 6-inch monokristalliner Siliziumwafer verwendet werden, aus dessen Fläche z.B. mittels eines Lasers die Form eines 4-inch Germaniumwafers geschnitten wird, so dass als Ablöseschicht ein dünner Rahmen aus monokristallinem Silizium entsteht. Dieser Rahmen und das Werkstück, ein 4-inch Germaniumwafer mit im Wesentlichen derselben Dicke wie der Rahmen, werden dann jeweils einzeln derart mit der Aufnahmeschicht verbunden, dass der Germaniumwafer innerhalb des Rahmens und in derselben Ebene wie der Rahmen liegt. Beim Ablösen der Festkörperschicht vom Werkstück wird dabei sowohl vom Rahmen wie auch vom Werkstück jeweils eine dünne Schicht abgelöst, wobei ein Vorteil dieser erfindungsgemäßen Anordnung darin besteht, dass die Beaufschlagung mit einem Spannungsfeld so gewählt werden kann, dass der Ablösevorgang im Rahmen beginnt und sich erst danach in das Werkstück fortsetzt, so dass sich Instabilitäten in der Anfangsphase des Ablösevorgangs oder im Randbereich der Aufnahmeschicht im Wesentlichen auf den Rahmen und viel weniger auf das Werkstück auswirken. Insbesondere können so größere Dickenschwankungen im Wesentlichen auf den Rahmen beschränkt werden, welcher als Opferschicht verwendet wird und aus wesentlich preisgünstigerem Material besteht als das eigentliche Werkstück. Mit anderen Worten: Das Werkstück wird innerhalb eines Rahmens aus einem kostengünstigeren Opfermaterial derart positioniert, dass durch den Ablösevorgang entstehende, unvermeidliche und nicht erwünschte Dickenschwankungen der abgelösten dünnen Schichten vorwiegend auf Bereiche des Rahmens beschränkt werden. Je nach mechanischen Eigenschaften wie z.B. Elastizitätsmodul oder Reißfestigkeit der verwendeten Materialien für die Ablöseschicht und das Werkstück kann es dabei vorteilhaft sein, spezifische Geometrien für die Aufnahme- und/oder Aufnahmeschicht zu wählen und/oder bestimmte mechanische Eigenschaften der Aufnahmeschicht, insbesondere deren Elastizitätsmodul, im Bereich des Rahmens lokal anders zu wählen als in den restlichen Bereichen der Aufnahmeschicht.

Die Ablöseschicht wird gemäß einer weiteren bevorzugten Ausführungsform der vorliegenden Erfindung durch mindestens ein weiteres Werkstück ausgebildet, wobei infolge der Beaufschlagung der Kompositstruktur mit dem Spannungsfeld von jedem Werkstück eine Festkörperschicht abgelöst wird.

Somit werden verschiedene Abschnitte der Aufnahmeschicht bevorzugt jeweils mit exponierten Oberflächen von mehreren verschiedenen Werkstücken verbunden, wobei die Aufnahmeschicht jeweils verschiedene zweite Grenzflächen mit den jeweiligen exponierten Oberflächen der verschiedenen Werkstücke bildet, wobei jede dieser verschiedenen zweiten Grenzflächen durch einen Rand begrenzt wird, welcher zumindest abschnittsweise im Wesentlichen an einen Rand mindestens einer anderen der verschiedenen zweiten Grenzflächen angrenzt oder welcher zumindest abschnittsweise im Wesentlichen an einen Rand der einen oder mehreren ersten Grenzflächen zwischen Aufnahmeschicht und Ablöseschicht angrenzt. Beispielsweise werden vier pseudoquadratische monokristalline Siliziumwafer in einer 2x2 Matrix so angeordnet, dass alle Wafer in derselben Ebene liegen und zwei benachbarte gerade Kanten jedes Wafers jeweils an je eine gerade Kante eines anderen Wafers angrenzen, wobei im Zentrum der Anordnung ein Zwischenraum verbleibt. Jeder Wafer wird nun mit einer exponierten Seite, welche in derselben Ebene liegt wie die jeweils entsprechende exponierte Seite der anderen Wafer, unter der Bildung von je einer zweiten Grenzfläche mit einer für alle Wafer gemeinsamen Aufnahmeschicht verbunden, so dass die Aufnahmeschicht mindestens alle vier Wafer sowie den Zwischenraum im Zentrum überlagert, bevorzugt aber eine noch größere Fläche aufweist. In Bereichen, wo die Aufnahmeschicht keinen Wafer überlagert, wird sie zumindest abschnittsweise unter der Bildung von einer oder mehreren ersten Grenzflächen mit der Ablöseschicht verbunden. Mittels einer solchen oder ähnlichen Ausführungsform ist es möglich, mit einer einzigen Anwendung des vorliegenden Verfahrens Festkörperschichten von mehreren Werkstücken abzulösen. Dabei kann je nach Ausführungsform die zweite Grenzfläche bei einem Werkstück an die zweite Grenzfläche bei einem oder mehreren anderen Werkstücken, oder aber an eine oder mehrere erste Grenzflächen zwischen Aufnahmeschicht und Ablöseschicht angrenzen. Je nach Anwendung werden dabei verschiedene Geometrien für die Anordnung der Werkstücke und/oder die Form der ersten und/oder zweiten Grenzflächen verwendet.

Das Werkstück wird gemäß einer weiteren bevorzugten Ausführungsform der vorliegenden Erfindung von einem Bereich der Ablöseschicht umschlossen, in dem eine sich durch den Riss ergebende Dickenschwankung geringer ist als in mindestens einem anderen Bereich der Ablöseschicht.

Das axiale Zentrum des Werkstücks und das axiale Zentrum der Ablöseschicht werden gemäß einer weiteren bevorzugten Ausführungsform der vorliegenden Erfindung voneinander beabstandet angeordnet.

Diese Ausführungsform ist vorteilhaft, da durch die versetzte Anordnung des Werkstücks zum Zentrum der Ablöseschicht die sich im Zentrum der Ablöseschicht ergebende Dickenschwankung soweit vom Werkstück beabstandbar ist, dass sie bevorzugt zumindest im Wesentlichen keinen Einfluss mehr auf die Dickenschwankung der abgespalteten Festkörperschicht hat bzw. der Einfluss reduziert ist.

Eine durch den Umfang der Ablöseschicht beschriebene erste Grundform weicht gemäß einer weiteren bevorzugten Ausführungsform der vorliegenden Erfindung von einer durch den Umfangs des Werkstücks beschriebenen zweiten Grundform ab, bevorzugt ist eine der Grundformen abschnittsweise gebogen und die von dem Umfang der Ablöseschicht beschriebene Grundform ist zumindest abschnittsweise geradlinig. Diese Ausführungsform ist vorteilhaft, da mittels der geometrischen Unterschiede zwischen dem Werkstück und der Ablöseschicht die Dickenschwankung steuerbar bzw. beinflussbar ist.

Die Ablöseschicht wird gemäß einer weiteren bevorzugten Ausführungsform der vorliegenden Erfindung durch einen Wafer gebildet, wobei der Wafer bevorzugt Silizium oder Germanium aufweist. Diese Ausführungsform ist vorteilhaft, da das Werkstück und die Ablöseschicht somit ähnliche Festigkeitseigenschaften haben, wodurch der Rissverlauf sehr gut kontrolliert werden kann.

Die Ablöseschicht gemäß einer weiteren bevorzugten Ausführungsform der vorliegenden Erfindung in dem Bereich, in dem sie das Werkstück in Umfangsrichtung umschließt, mit der Aufnahmeschicht unter Bildung einer Kontaktfläche gekoppelt wird, wobei der Riss zumindest abschnittsweise ein Ablösen der Ablöseschicht von der Aufnahmeschicht bewirkt.

Gemäß dieser Ausführungsform wird somit bevorzugt zumindest zeitweise und bevorzugt stets zeitgleich mit oder zeitlich kurz vor, bevorzugt weniger als eine Sekunde vor dem Ablösen der Festkörperschicht vom Werkstück die Ablöseschicht zumindest abschnittsweise entlang mindestens einer der einen oder mehreren ersten Grenzflächen von der Aufnahmeschicht abgelöst, bevorzugt in Abschnitten, wo ein Rand mindestens einer der einen oder mehreren ersten Grenzflächen zumindest abschnittsweise im Wesentlichen an einen Rand der zweiten Grenzfläche angrenzt, wobei die Abschnitte der einen oder mehreren ersten Grenzflächen, entlang welcher die Ablöseschicht abgelöst wird, zumindest abschnittsweise bevorzugt parallel zu und weiter bevorzugt im Wesentlichen in derselben Ebene liegen wie die sich innerhalb des Werkstücks erstreckende Ebene, von der die Festkörperschicht abgelöst wird. Die Aufnahmeschicht weist in dieser ersten bevorzugten Ausführungsform der Erfindung bevorzugt ein Polymer, insbesondere Polydimethylsiloxane (PDMS), auf. Die Ablöseschicht besteht in dieser Ausführungsform bevorzugt aus demselben Material wie die Aufnahmeschicht oder aus einem anderen Material wie z.B. Aluminium oder Papier, wobei bevorzugt die Haftung in mindestens einer der einen oder mehreren ersten Grenzflächen zwischen Ablöseschicht und Aufnahmeschicht so gewählt ist, dass die Reißfestigkeit dieser Grenzfläche zumindest abschnittsweise kleiner als oder gleich groß wie die Reißfestigkeit des Materials des Werkstücks ist.

In den beschriebenen Ausführungsbeispielen wurde insbesondere dargestellt, wie Schichtsysteme bestehend beispielsweise aus einem 4-inch, runden Germaniumwafer als Werkstück und einem aus einem 6-inch pseudoquadratischen Siliziumwafer geschnittenen Siliziumrahmen als Ablöseschicht sowie einer aus einer Metallplatte und einer Polymerschicht bestehenden Stabilisierungsschicht zur Lösung der eingangs erwähnten Aufgabe bei der Herstellung von Wafern verwendet werden können. In weiteren bevorzugten Ausführungsformen kann die Ablöseschicht auch aus einem oder mehreren anderen Materialien als Silizium bestehen, wie z.B. Glas, Papier, oder auch aus einer PDMS-Folie. Insbesondere ist es gemäß dieser Ausführungsform möglich, als Ablöseschicht lediglich die Grenzfläche zwischen Aufnahmeschicht und Stabilisierungsschicht zu verwenden, wobei dann z.B. anstelle der Reißfestigkeit des Materials der Ablöseschicht entsprechend die Reißfestigkeit des Interfaces von Bedeutung ist. Außerdem können in einem Schichtsystem auch mehrere räumlich verteilte Ablöseschichten aus verschiedenen Materialien verwendet werden. Zudem kann das Werkstück aus einem anderen Material als Germanium bestehen, wie z.B. Silizium, GaAs, GaN, Saphir, SiC, Quartz, Glas, etc und/oder es können Werkstücke verwendet werden, die bereits aktive oder passive elektrische Bauteile oder andere funktionale Strukturen enthalten. Außerdem müssen die Dicken von Werkstück und Ablöseschicht nicht notwendigerweise gleich sein sondern können im Gegenteil stark unterschiedlich sein, beispielsweise ein sehr dünner (z.B. < 1 Mikrometer dicker) Film als Ablöseschicht und ein dicker (z.B. > 800 Mikrometer dicker) Wafer als Werkstück. Zudem müssen die Oberflächen von Werkstück und Ablöseschicht nicht in derselben Ebene liegen, wobei sie aber bevorzugt im Wesentlichen zueinander parallel sein sollten, und wobei die Ablöseschicht bevorzugt in einer Ebene liegen sollte, die durch das Werkstück oder nicht zu weit (bevorzugt < 1 mm) davon entfernt verläuft. Schließlich muss die Stabilisierungsschicht nicht aus einem Verbund (z.B. aus einer Metallplatte und einer PDMS-Schicht) bestehen, sondern kann auch nur aus einer einzelnen Schicht bestehen (z.B. einer PDMS-Folie) oder sie kann insbesondere im Fall von sehr dicken (bevorzugt > 1 cm dicken) Werkstücken und Ablöseschichten auch ganz wegfallen.

Die Ablöseschicht gemäß einer weiteren bevorzugten Ausführungsform der vorliegenden Erfindung eine Oberfläche des Werkstücks in der Haupterstreckungsebene des Werkstücks zumindest abschnittsweise überlagert, wobei die Ablöseschicht bevorzugt an dem Werkstück anhaftet. Diese Ausführungsform ist vorteilhaft, da durch die Ablöseschicht definiert Spannungen in das Werkstück einleitbar sind.

Die Kontaktfläche zwischen der Ablöseschicht und der Aufnahmeschicht befinden sich gemäß einer weiteren bevorzugten Ausführungsform der vorliegenden Erfindung in einer Ebene, die sich parallel zu der von der Aufnahmeschicht aufgenommenen Oberfläche des Werkstücks erstreckt, bevorzugt entspricht der Abstand zwischen der Kontaktfläche und der Oberfläche des Werkstücks im Wesentlichen der Dicke der herzustellenden Festkörperschicht. Diese Ausführungsform ist vorteilhaft, da über den Abstand zwischen der Kontaktfläche und der Oberfläche des Werkstücks sehr einfach die Dicke der herzustellenden Festkörperschicht festlegbar bzw. einstellbar ist.

Gemäß einer weiteren bevorzugten Ausführungsform der vorliegenden Erfindung weist die Ablöseschicht ein Polymer, insbesondere PDMS, auf und die Aufnahmeschicht weist bevorzugt ein Metall, insbesondere Aluminium, auf.

Weiterhin ist denkbar, dass zwischen jeweils zwei im Rahmen von zuvor oder nachfolgend beschriebenen Ausführungsformen miteinander verbundenen Schichten eine oder mehrere Zwischenschichten eingefügt werden, welche beispielsweise die Haftung zwischen den beiden verbundenen Schichten erhöht oder ein späteres Ablösen der beiden Schichten voneinander erleichtert. Beispielsweise wird in einer bevorzugten Ausführungsform zwischen der ersten bzw. der zweiten exponierten Oberfläche des Werkstücks und der Aufnahmeschicht bzw. der Stabilisierungsschicht eine Opferschicht, welche beispielsweise ein Sol-Gel aufweist, eingefügt, welche ein späteres Ablösen der Aufnahmeschicht bzw. der Stabilisierungsschicht von der abgelösten Festkörperschicht erleichtert. Beispielsweise wird in einer weiteren bevorzugten Ausführungsform zwischen der Aufnahmeschicht und der Ablöseschicht eine Haftschicht eingefügt, mit welcher die Haftung zwischen der Aufnahmeschicht und der Ablöseschicht reproduzierbar eingestellt werden kann.

Weiterhin ist denkbar, dass eine oder mehrere der verwendeten Schichten einzeln oder im Verbund mit einer oder mehreren der anderen verwendeten Schichten nach dem Ablösen der Festkörperschicht und gegebenenfalls nach dem Ablösen von weiteren Schichten und/oder einer etwaigen Reinigung für eine neuerliche Anwendung des vorliegenden Verfahrens wieder verwendet werden.

Ferner werden eine oder mehrere der im Rahmen von anderen hier beschriebenen Ausführungsformen erwähnten Schichten als Kompositstruktur bzw. Laminat von miteinander verbundenen Einzelschichten gebildet und/oder bestehen aus heterogenen Materialien, wie beispielsweise eine PDMS-Schicht mit darin eingegossenen Silica-Partikeln.

Gemäß einer weiteren bevorzugten Ausführungsform der vorliegenden Erfindung werden die Funktionen von jeweils zwei im Rahmen von anderen hier beschriebenen Ausführungsformen miteinander verbundenen Schichten durch eine einzige Schicht wahrgenommen. Beispielsweise wird in einer Ausführungsform als Aufnahmeschicht und Ablöseschicht eine einzelne PDMS-Schicht verwendet, und/oder in einer anderen Ausführungsform wird beispielsweise als Ablöseschicht und Stabilisierungsschicht eine einzelne PDMS-Schicht verwendet.

Gemäß einer weiteren bevorzugten Ausführungsform der vorliegenden Erfindung bildet die Aufnahmeschicht beim Verbinden mit einer oder mehreren exponierten Oberflächen des Werkstücks mehrere zweite Grenzflächen mit einer oder mehreren exponierten Oberflächen des Werkstücks, wobei jede dieser mehreren zweiten Grenzflächen jeweils durch einen Rand begrenzt wird, welcher zumindest abschnittsweise im Wesentlichen an jeweils einen Rand mindestens einer der einen oder mehreren ersten Grenzflächen angrenzt.

Gemäß einer weiteren bevorzugten Ausführungsform der vorliegenden Erfindung weist die Aufnahmeschicht und/oder die Ablöseschicht und/oder die Stabilisierungsschicht bevorzugt ein Polymer auf bzw. besteht zumindest teilweise und bei der Aufnahmeschicht besonders bevorzugt vollständig aus einem Polymer, wobei beim Beaufschlagen der Kompositstruktur, die bevorzugt zumindest aus der Aufnahmeschicht, der Ablöseschicht und dem Werkstück besteht, mit einem inneren und/oder äußeren Spannungsfeld mindestens ein Teil und bevorzugt mehrere Teile des Polymers, insbesondere PDMS, durch genau einen Glasübergang, mindestens einen Glasübergang oder mehrere, insbesondere zeitliche versetzte, Glasübergänge gehen. Es ist hierbei denkbar, dass das Initiieren des Glasübergangs infolge z.B. mechanischer und/oder chemischer und/oder thermischer und/oder akustischer Effekte bzw. Beaufschlagungen bewirkt wird.

Nachdem das Schichtsystem Metallplatte-Polymerschicht-Werkstück/Ablöseschicht-Polymerschicht z.B. unter Verwendung eines der vorher beschriebenen Ausführungsbeispiele hergestellt und das Polymer ausgehärtet ist, wird, wie in den im Stand der Technik beschriebenen Referenzen üblich, z.B. durch thermisch induzierte Spannungen ein dünner Wafer vom Werkstück abgelöst sowie, bei entsprechenden Ausführungsformen, zusätzlich und im Wesentlichen gleichzeitig dazu auch eine dünne Schicht von der Ablöseschicht abgelöst, wobei ein Teil des Schichtsystems (die Aufnahmeschicht) noch auf einer Seite des vom Werkstück abgelösten dünnen Wafers bzw. der dünnen von der Ablöseschicht abgelösten Schicht anhaftet. Dieser Teil des Schichtsystems kann dann vom hergestellten Wafer z.B. mit mechanischen oder chemischen Methoden abgelöst werden, wie in den erwähnten Referenzen dargestellt. Am verbleibenden Rest des Werkstücks und der Ablöseschicht haftet in den beschriebenen Beispielen entsprechend auf einer Seite noch der andere Teil des Schichtsystems (die Stabilisierungsschicht). Auch dieser kann z.B. mit mechanischen oder chemischen Methoden abgelöst werden, wie ebenfalls in den erwähnten Referenzen dargestellt. Um das Ablösen der Schichtsysteme nach dem Abspalten des Wafers zu erleichtern, kann es zudem hilfreich sein, das Schichtsystem leicht zu krümmen. Weiterhin ist das Schichtsystem bevorzugt wiederverwendbar. Nachdem das Schichtsystem (mit oder ohne verbundene Metallplatte) vom hergestellten Werkstück bzw. Wafer abgelöst ist, kann es - falls gewünscht - gereinigt und danach auf ein neues Werkstück aufgebracht werden, wobei je nach Ausführungsform gegebenenfalls auch die Ablöseschicht abgelöst und erneuert werden muss. Dadurch ist es möglich auf vorteilhafte Weise, dasselbe Schichtsystem (mit oder ohne verbundene Metallplatte) mehrfach zur Herstellung von Wafer zu verwenden. Dies kann den Materialverbrauch und die Kosten des Gesamtprozesses signifikant reduzieren. Für eine Wiederverwendung des Schichtsystems ist es insbesondere vorteilhaft, zur Befestigung des Werkstücks und gegebenenfalls der Ablöseschicht einen wieder auflösbaren Kleber zu verwenden, da in diesem Fall nach dem Auflösen der Kleberschicht am Schichtsystem keine Kleberrückstände mehr verbleiben.

Gemäß einer weiteren Ausführungsform der vorliegenden Erfindung werden die Aufnahmeschicht und die Ablöseschicht bzw. die Ablöseschicht und die Stabilisierungsschicht zur Ausbildung der Trägereinheit stoffschlüssig miteinander verbunden, wobei insbesondere die Aufnahmeschicht und/oder die Stabilisierungsschicht als Folie und bevorzugt als vorgefertigte Folie erzeugt und jeweils an die Ablöseschicht angeklebt wird. Je nach Ausführungsform kann auch die Ablöseschicht als Folie und bevorzugt als vorgefertigte Folie erzeugt werden.

Die Verwendung von vorgefertigten Folien hat den Vorteil, dass die Fertigung und Qualifikation der Polymerschichten unabhängig von der Festkörperschichtherstellung bzw. Waferfertigung geschehen kann. Mit anderen Worten: die Eigenschaften der einzelnen Polymerschichten können somit unabhängig von anderen Prozessschritten definiert und kontrolliert werden. Speziell können beispielsweise auch strukturierte Folien verwendet werden, wo z.B. die Foliendicke je nach Position gezielt variiert wird, so dass Polymerschichten mit definierten Dickenprofilen möglich sind.

Zur Herstellung der Polymerfolien ist bevorzugt PDMS Sylgard 184 von Dow Corning verwendbar. Dies ist ein zweikomponentiges Gemisch, das thermisch ausgehärtet wird (z.B. Mischverhältnisse zwischen Härter: Basismaterial von bevorzugt 1:100 bis 1:1 und besonders bevorzugt von 1:30 bis 1:3). Zum Härten sind - je nach Härtezeit - Temperaturen von Raumtemperatur bis ca. 300°C und bevorzugt bis 200°C, vorzugsweise von Raumtemperatur bis ca. 120°C, vorsehbar. Bevorzugt sind Härtezeiten zwischen ca. 1-120 Minuten (bei hohen Temperaturen) und 1-6 Tagen (bei Raumtemperatur) vorsehbar. Bei PDMS Sylgard 184 handelt es sich vor dem Härten um eine viskose Flüssigkeit, die z.B. mittels Gießverfahren auf eine bevorzugt glatte Oberfläche (z.B. einen Spiegel) aufgebracht wird und dort zu einer Folie aushärtet. Die Folie wird von dieser Oberfläche dann abgezogen (z.B. mechanisch), gegebenenfalls weiterverarbeitet, und danach auf die zu beschichtende Oberfläche aufgebracht. Außerdem kann die fertige Folie bereits vor dem Aufbringen untersucht und ihre Qualität überprüft werden (z.B. mit üblichen mechanischen, optischen oder elektrischen Messverfahren, etc.). Neben dem hier beschriebenen Verfahren zur Folienherstellung sind viele andere Verfahren in der Industrie üblich (z.B. Herstellung durch Extrusion), welche ebenfalls für die vorliegende Erfindung anwendbar sind.

Die Aufnahmeschicht und/oder die Stabilisierungsschicht werden gemäß einer weiteren bevorzugten Ausführungsform der vorliegenden Erfindung mittels einer Klebeschicht, plasmaaktiviertem Kleben oder Auflaminieren mit der Ablöseschicht verbunden.

Weiterhin bezieht sich die Erfindung auf einen Wafer, der nach einem Verfahren gemäß einem der Ansprüche 1-8 hergestellt wird.

Ferner bezieht sich die Erfindung auf eine Vorrichtung zum Herstellen von Festkörperschichten, insbesondere von Wafern. Die erfindungsgemäße Vorrichtung umfasst mindestens eine Einrichtung zum Induzieren von definierten lokalen Spannungen in eine Kompositstruktur zum Abspalten einer Festkörperschicht von einem Werkstück,
wobei die Einrichtung eine Aufnahmeschicht aufweist, die eine im Wesentlichen ebene Oberfläche zum Aufnehmen des Werkstücks ausbildet und wobei ein Spannungsinduzierungsmittel derart angeordnet ist, dass es mit der Aufnahmeschicht zusammenwirkt,
wobei die Oberfläche zum Aufnehmen des Werkstücks größer ist als die Werkstückoberfläche, die damit koppelbar ist, und
wobei auf der Oberfläche zum Aufnehmen des Werkstücks eine Ablöseschicht aufbringbar ist, die das Werkstück in Umfangsrichtung zumindest teilweise umschließt,
wobei durch die Spannungsinduziermittel ein Riss in der Ablöseschicht erzeugbar ist, der auf das Werkstück übergeht.

Weiterhin kann sich die vorliegende Erfindung auf eine Trägereinheit zum Aufnehmen mindestens einer Festkörperschicht beziehen, wobei die Trägereinheit wie hierin beschrieben, ausgebildet sein kann.

Weitere Vorteile, Ziele und Eigenschaften der vorliegenden Erfindung werden anhand nachfolgender Beschreibung anliegender Zeichnungen erläutert, in welchen beispielhaft erfindungsgemäße Wafer und Vorrichtungen dargestellt sind. Bauteile oder Elemente der erfindungsgemäßen Wafer und Vorrichtungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Es zeigen:
- Fig. 1a/b: einen ersten bevorzugten Schichtaufbau;

- Fig. 2: einen zweiten bevorzugten Schichtaufbau;
- Fig. 3a/b: einen dritten bevorzugten Schichtaufbau;
- Fig. 4a/b: eine bevorzugte räumliche Ausgestaltung einzelner Schichten;
- Fig. 5a/b: ein bevorzugter Schichtaufbau mit einem darin gekennzeichneten Rissverlauf;
- Fig. 6a/b: ein vierter bevorzugter Schichtaufbau;
- Fig. 7a/b: eine Anordnung mit mehreren Werkstücken;
- Fig. 8a/b: eine weitere Anordnung mit mehreren Werkstücken in einer Draufsicht und in einer Seitenansicht bzw. Schnittdarstellung;
- Fig. 9a/b/c: verschiedene Anordnungen mehrerer Werkstücke;
- Fig. 10: eine Schichtanordnung mit PDMS-Quadrat in der Draufsicht;
- Fig. 11 a/b: weitere Schichtanordnungen mit mehreren Werkstücken im PDMS-Quadrat;
- Fig. 12a/b: Schichtanordnungen mit einem Werkstück im PDMS-Tropfen;
- Fig. 13: eine Schichtanordnung mit PDMS-Doppeltropfen;
- Fig. 14a/b: weitere Schichtanordnungen mit mehreren Werkstücken im PDMS-Doppeltropfen;
- Fig. 15a/b: weitere Schichtanordnungen mit mehreren Werkstücken; und
- Fig. 16a/b/c/d: Schichtanordnungen zum Durchführen eines Interfacesplits.

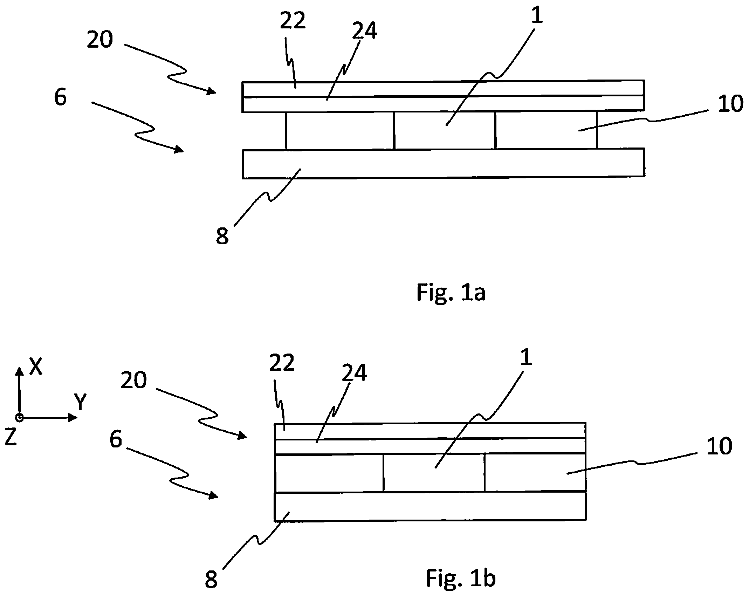

In Fig. 1a ist eine Anordnung gezeigt, gemäß der eine, insbesondere mit Hilfe eines Lasers, Scheibe aus dem Zentrum einer Ablöseschicht 10, insbesondere aus einem 6-inch pseudoquadratischen monokristallinen Siliziumwafers, entfernt wurde, so dass die herausgeschnittene Stelle exakt die Form eines Werkstücks 1, insbesondere eines 4-inch Germaniumwafers (mit Flat) hat, aber leicht größer ist, so dass ein flacher Rahmen aus Silizium resultiert. Ferner wird ein entsprechendes Werkstück 1, insbesondere ein Germaniumwafer, in dem derart präparierten Siliziumrahmen positioniert, welcher zudem eine ähnliche Dicke wie die Ablöseschicht 10 bzw. der Siliziumrahmen aufweist, so dass die inneren Ränder des Siliziumrahmens dicht an den Rand des Germaniumwafers anliegen, insbesondere diesen kontaktieren. Schließlich wird ein Bruch durch die gesamte Anordnung aus Siliziumrahmen 10 und Germaniumwafer 1 geführt, und es zeigt sich, dass bei den abgelösten Schichten auch hier in den Bereichen im Innern der Anordnung, und insbesondere auch am Rand des Germaniumwafers, nur relativ geringe Dickenschwankungen auftreten.

Die Anordnung aus Ablöseschicht 10 und Werkstück 1 ist gemäß dieser Darstellung einerseits durch ein Aufnahmeschicht 8 und andererseits durch eine Stabilisierungsschicht 20 überdeckt. Die Stabilisierungsschicht 20 besteht dabei bevorzugt aus einer Metallschicht 22 und einer ersten Polymerschicht 24. Weiterhin bilden die Aufnahmeschicht 8 und die Ablöseschicht 10 zusammen bevorzugt eine Trägereinheit 76 aus.

Zusätzlich oder alternativ zu einer solchen geeigneten Positionierung des Werkstücks 1 innerhalb der Bruchfläche ist es möglich, z.B. auch unter Verwendung der bereits in früheren Patentanmeldungen der Anmelderin beschriebenen Methoden, den Bruchverlauf an sich zu beeinflussen. Beispielsweise wurde erkannt, dass mittels der Geometrien der verwendeten Schichtstrukturen, insbesondere die Geometrien der Aufnahmeschicht 8 und der Stabilisierungsschicht 20, die lokale Spannungsverteilung und der Bruchverlauf 48 kontrollierbar beeinflusst werden können. Im Rahmen der vorliegenden Erfindung kann eine derartige Kontrolle des Bruchverlaufs bzw. Rissverlaufs 48 besonders vorteilhaft realisiert werden, da viele der dazu benötigten Schichtstrukturen außerhalb des Werkstücks 1 positioniert und damit unabhängig von der Geometrie des Werkstücks 1 gewählt werden können.

In Fig. 1b sind die einzelnen Schichten 22, 24, 8 in der Y-Z-Ebene im Wesentlichen oder genau mit den gleichen Abmessungen, insbesondere den Abmessungen der Ablöseschicht 10 und/oder des Werkstücks 1, ausgebildet. Es ist hierbei auch denkbar, dass sich einzelne oder alle Schichten 22, 24, 8 in der Y-Z-Ebene abschnittsweise weniger weit erstrecken als die Ablöseschicht 10 und/oder das Werkstück 1.

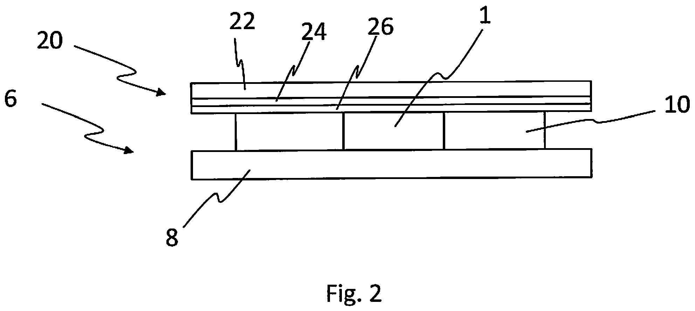

In dem in Fig. 2 gezeigten Beispiel einer weiteren erfindungsgemäßen Ausführungsform wird als Werkstück 1 bevorzugt ein ungefähr 400 Mikrometer dicker, runder monokristalliner Germaniumwafer von 4 Inch Durchmesser verwendet. Als Ablöseschicht 10 wird bevorzugt eine Schicht aus monokristallinem Silizium verwendet, welche bevorzugt gleich dick wie der Germaniumwafer ist und in diesem Ausführungsbeispiel aus einem ungefähr 400 Mikrometer dicken, 6-inch pseudoquadratischen, monokristallinen Siliziumwafer hergestellt wird. Außerdem wird in diesem Ausführungsbeispiel eine Stabilisierungsschicht 20 verwendet, welche als Kompositstruktur aus einer ebenen, bevorzugt zwischen 0.1 und 10 mm dicken Aluminiumplatte 22 und einer bevorzugt zwischen 1 und 10 mm dicken ersten PDMS-Folie realisiert ist, wobei sowohl die Aluminiumplatte 22, wie die erste PDMS-Folie 24 Flächen von je ungefähr 200 x 200 mm haben. Schließlich wird als Aufnahmeschicht eine zweite PDMS-Folie 26 verwendet, welche bevorzugt zwischen 1 und 10 mm dick ist und bevorzugt auch eine Fläche von ungefähr 200 x 200 mm hat.

Zur Herstellung der Stabilisierungsschicht 20 wird die erste PDMS-Folie 24 nach ihrer Herstellung auf die Oberfläche der ebenen Metallplatte 22 aufgeklebt. Im Folgenden wird als Metallplatte 22 bevorzugt eine Platte aus Aluminium beschrieben; es können aber auch Platten aus anderen geeigneten Materialien (z.B. Messing, Stahl, Silizium etc.) verwendet werden. Dabei ist eine gute Haftung dieser ersten Folie 24 auf der Metallplatte 22 wichtig: die Verbindung zwischen Metallplatte 22 und Folie 24 muss genügend große Scherkräfte für das Abspalten sowie große Temperaturschwankungen für das thermische Induzieren der nötigen Spannungen aushalten können. Die Haftung kann z.B. durch mechanisches Aufrauen der Metalloberfläche, Eloxieren des Aluminiums, Ätzprozesse, etc. verbessert werden.

Für das Aufkleben der ersten Folie 24 bietet sich z.B. ein dünner PDMS-Film als Kleber an (z.B. ebenfalls unter Verwendung von Sylgard 184). Das PDMS wird in diesem Beispiel im flüssigen Zustand auf beide zu verklebenden Oberflächen dünn aufgetragen (einige Milliliter für eine 200x200 mm Oberfläche). Danach wird die Folie 24 auf die Metallplatte 22 aufgelegt und bevorzugt mit einer Rolle oder Walze unter leichtem Druck angepresst. Durch Hin- und Herbewegen der Rolle verteilt sich der Kleberfilm unter der Folie, Luftblasen werden entfernt. Die Aushärtung des Klebers kann z.B. bei Temperaturen zwischen Raumtemperatur und ca. 200°C erfolgen. Die Härtezeiten variieren, wie bei der Folienherstellung, abhängig von der Härtetemperatur (siehe oben). Alternativ zum beschriebenen Verfahren kann die erste Folie 24 auch mit anderen Verfahren auf die Metallplatte 22 aufgeklebt werden, beispielsweise unter Verwendung eines Vakuum-Laminators. Schließlich kann die Folie 24 auch bevorzugt direkt (ohne Kleber) mit der Oberfläche der Metallplatte 22 verbunden werden, z.B. mittels "Plasma activated bonding" (z.B. Aktivierung der PDMS-Folie in Stickstoffplasma, Aufpressen der Folie auf Metallplatte, ggf. "Annealing") oder z.B. durch Auflaminieren (Aufschmelzen) einer thermoplastischen Folie (z.B. Geniomer von Wacker Silicones).

Zur Herstellung der Ablöseschicht 10 wird bevorzugt aus dem Zentrum der Ablöseschicht 10, insbesondere dem 6-inch pseudoquadratischen Silizumwafers, z.B. mittels eines YAG-Lasers eine Lücke geschnitten, welche im Wesentlichen bzw. exakt die Form des Germaniumwafers 1 hat, aber leicht, bevorzugt weniger als 1 mm, größer ist, so dass ein flacher Rahmen aus Silizium entsteht.

Nach der Herstellung der Stabilisierungsschicht 20 bzw. dem Aufkleben der ersten Folie 24 auf die Metallplatte 22 und dem Aushärten des Klebers wird bevorzugt mit einem vorzugsweise analogen Verfahren das Werkstück 1 (im vorliegenden Beispiel der dicke Germaniumwafer) und die Ablöseschicht 10 (im vorliegenden Beispiel der flache Rahmen aus Silizium) auf die durch die noch freie Oberfläche der ersten Folie 24 gebildete Oberfläche der Stabilisierungsschicht 20 geklebt, wobei der Germaniumwafer 1 und der Silizumrahmen 10 derart positioniert werden, dass sie im Wesentlichen relativ zueinander in derselben Ebene liegen, so dass der Germaniumwafer 1 durch den Silizumrahmen 10 umrahmt wird, d.h., der Rand des Germaniumwafers 1 überall an den durch die herausgeschnittene Lücke gebildeten inneren Rand des Siliziumrahmens 10 angrenzt.

Anschließend an oder gleichzeitig mit dem Aufkleben von Werkstück 1 und Ablöseschicht 10 auf die Stabilisierungsschicht 20 wird bevorzugt mit einem vorzugsweise analogen Verfahren die Aufnahmeschicht 8, d.h. im vorliegenden Ausführungsbeispiel eine weitere PDMS-Folie 8, auf die der Stabilisierungsschicht 20 jeweils abgewandte Seite des Werkstücks 1 und der Ablöseschicht 10, d.h. auf die jeweils noch freie Seite des Germaniumwafers 1 und des Siliziumrahmens 10, geklebt. Nach dem Aushärten des Klebers liegt damit ein Schichtsystem wie folgt vor: Metallplatte 22 - erste PDMS-Folie 24 (bildet zusammen mit der Metallplatte die Stabilisierungsschicht 20) - Siliziumrahmen (Ablöseschicht 10) mit eingerahmtem Germaniumwafer (Werkstück 1) - weitere PDMS-Folie (Aufnahmeschicht 8), wobei Siliziumrahmen 10 und Germaniumwafer 1 ungefähr gleich dick sind und im Wesentlichen in derselben Ebene liegen.

Die Aufnahmeschicht 8 ist gemäß einer weiteren bevorzugten Ausführungsform der vorliegenden Erfindung strukturiert. Diese Ausführungsform ist vorteilhaft, da dadurch auch speziell strukturierte Folien verwendet werden können, wobei z.B. die Foliendicke je nach Position gezielt variiert wird, so dass eine oder mehrere Polymerschicht/en mit definierten Dickenprofilen möglich sind. So kann eine Aufnahmeschicht z.B. dergestalt realisiert werden, dass sie in Bereichen, wo sie mit dem Werkstück 1 verbunden ist, eine andere Dicke aufweist als in Bereichen, wo sie mit der Ablöseschicht 10 verbunden ist. Auch weitere Eigenschaften der Aufnahmeschicht 8, insbesondere deren Elastizitätsmodul, können in analoger Weise je nach Position gezielt variiert werden. Dadurch kann die Bruchpropagation beim Ablösevorgang lokal besser kontrolliert werden, was insbesondere nicht erwünschte Dickenschwankungen und lokale Rauheiten des hergestellten Wafers reduzieren kann. Insbesondere können dadurch z.B. für den Fall, dass für die Bruchpropagation wichtige mechanische Eigenschaften der Ablöseschicht 10, z.B. das Elastizitätsmodul, signifikant anders als die entsprechenden mechanischen Eigenschaften des Werkstücks 1 sind, negative Effekte wie z.B. übermäßige Oszillationen beim Übergang der Bruchfront aus der Ablöseschicht 10 in das Werkstück 1 reduziert werden.

Gemäß einer weiteren bevorzugten Ausführungsform der vorliegenden Erfindung wird die Aufnahmeschicht 8 durch die Aufbringung eines zumindest zeitweise fließfähigen Materials auf das Werkstück 1 und/oder die Ablöseschicht 10 und/oder die Stabilisierungsschicht 20 und eine Verfestigung, insbesondere Aushärtung, des Materials ausgebildet.

Im Rahmen einer Prozessalternative ist es bei diesem Anwendungsbeispiel auch möglich, eine oder mehrere der verwendeten Polymerschichten (für die Stabilisierungsschicht 20 und/oder die Aufnahmeschicht) nicht als vorgefertigte Folie aufzukleben, sondern direkt in situ herzustellen. Die Stabilisierungsschicht 20, bestehend aus Metallplatte 22 und erster PDMS-Schicht 24, kann so beispielsweise wie folgt hergestellt werden: Eine erste vorgegebene Menge flüssiges PDMS wird auf die Metallplatte 22 aufgetragen. Die Metallplatte 22 ist dabei horizontal ausgerichtet, so dass das PDMS infolge der Schwerkraft gleichmäßig bzw. im Wesentlichen gleichmäßig zerläuft und eine Schicht konstanter bzw. im Wesentlichen konstanter Dicke bildet. Ein Überfließen an den Rändern kann durch eine geeignete Schalungsvorrichtung oder z.B. durch die Oberflächenspannung des PDMS selbst verhindert werden. Zuletzt wird diese flüssige PDMS-Schicht direkt auf der Metallplatte 22 gehärtet, ein separates Kleben kann dadurch entfallen.

Die Schicht 26 kann dabei optional ergänzt werden und eine zweite Polymerschicht 26 ausbilden, welche die erste Polymerschicht 24 mit der Trägereinheit 6 bzw. der Ablöseschicht 10 und/oder dem Werkstück 1 verbindet.

Nach dem Aushärten der ersten PDMS-Schicht 24 auf der Metallplatte 22, d.h. nach der Vollendung der Herstellung der Stabilisierungsschicht 20, wird mit einem analogen Verfahren das Schichtsystem bestehend aus Stabilisierungsschicht 20, Werkstück 1, Ablöseschicht 10 und Aufnahmeschicht 8, bevorzugt wie folgt hergestellt: Eine zweite vorgegebene Menge flüssiges PDMS 26 wird auf die noch freie Seite der ersten PDMS-Schicht 24 aufgetragen. Die Metallplatte 22 mit der ersten PDMS-Schicht 24 ist dabei horizontal ausgerichtet, so dass das flüssige PDMS infolge der Schwerkraft gleichmäßig bzw. im Wesentlichen gleichmäßig zerläuft und eine zweite PDMS-Schicht 26 konstanter bzw. im Wesentlichen konstanter Dicke bildet. Ein Überfließen an den Rändern kann durch eine geeignete Schalungsvorrichtung oder z.B. durch die Oberflächenspannung des PDMS selbst verhindert werden. Zuletzt wird diese zweite flüssige PDMS-Schicht 26 direkt auf der ersten PDMS-Schicht 24 auf der Metallplatte 22 gehärtet, ein separates Kleben entfällt dadurch.

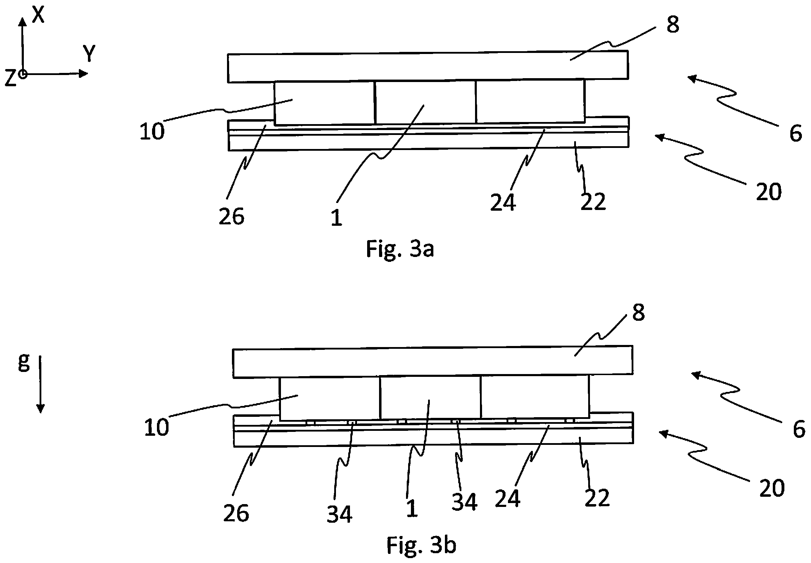

Das Werkstück 1 und die Ablöseschicht 10 werden gemäß einer weiteren bevorzugten Ausführungsform der vorliegenden Erfindung, die in Fig. 3a gezeigt ist, vor der Verfestigung der zweiten flüssigen PDMS-Schicht 26 mit dem flüssigen PDMS in Kontakt gebracht, wobei das Werkstück 1 und die Ablöseschicht 10 zumindest abschnittsweise in das flüssige PDMS eintauchen.

Gemäß diesem Ausführungsbeispiel kann somit auf vorteilhafte Weise bevorzugt vollständig auf das Kleben von vorgefertigten Polymerfolien verzichtet werden. Dabei wird, wie oben beschrieben, eine erste Menge flüssiges Material, insbesondere flüssiges Polymer, wie vorzugsweise PDMS, direkt auf die Metallplatte 22 aufgebracht, wobei diese bevorzugt horizontal ausgerichtet und an den Rändern bevorzugt mit einem geeigneten Abschluss (Schalung) versehen ist, welche besonders bevorzugt das Überfließen des PDMS verhindert. Dadurch entsteht eine Art Becken gefüllt mit einer Schicht flüssigem PDMS. Das flüssige PDMS wird dann ausgehärtet, wodurch eine erste feste PDMS-Schicht 24 entsteht, deren Dicke über die erste Menge an aufgebrachtem flüssigem PDMS kontrolliert werden kann. Danach wird erneut in einem analogen Verfahren eine zweite Menge flüssiges Material, insbesondere ein flüssiges Polymer, vorzugsweise PDMS, aufgebracht, dieses Mal direkt auf die erste bereits feste PDMS-Schicht 24, so dass wieder ein mit flüssigem PDMS gefülltes Becken entsteht. Das Werkstück 1 (z.B. ein Germaniumwafer) und die Ablöseschicht 10 (z.B. ein dünner Siliziumrahmen) werden bevorzugt allseitig mit einer dünnen Schicht flüssigem PDMS benetzt und dann in das Becken mit flüssigem PDMS getaucht (die vorherige Benetzung mit PDMS reduziert die Bildung von Luftblasen an der Waferoberfläche). Durch die Schwerkraft sinken das Werkstück 1 und die Ablöseschicht 10 an den Boden des Beckens, wo sie in geringem Abstand zur Oberfläche der ersten festen PDMS-Schicht 24 zur Ruhe kommen, wobei die Positionierung so gewählt wird, dass das Werkstück 1 zumindest abschnittsweise von der Ablöseschicht 10 umrahmt wird und Werkstück 1 und Ablöseschicht 10 im Wesentlichen in derselben Ebene liegen.

Die Distanz zwischen dem Werkstück 1 bzw. der Ablöseschicht 10 und der ersten festen PDMS-Schicht 24 ist bevorzugt durch das Gleichgewicht zwischen Schwerkraft / Auftrieb des Werkstücks 1 bzw. der Ablöseschicht 10 und der Oberflächenspannung des PDMS bestimmt. Diese Distanz kann durch künstliches Erhöhen der Schwerkraft (z.B. mittels einer Zentrifuge) verringert werden.

Der Bodenabstand, d.h. der Abstand von Werkstück 1 und Ablöseschicht 10 zur Oberfläche der ersten festen PDMS-Schicht 24 ist gemäß einer weiteren bevorzugten Ausführungsform der vorliegenden Erfindung, die in Fig. 3b gezeigt ist, einstellbar, insbesondere mittels einer Erhöhung der von Werkstück 1 und Ablöseschicht 10 auf den Boden des Beckens ausgeübten Normalkraft oder durch die Einbringung von Abstandshaltern 34. Durch geeignete Wahl dieses Abstands zur Oberfläche der ersten festen PDMS-Schicht 24 und durch geeignete Wahl der Dicke der ersten festen PDMS-Schicht 24 kann somit der Abstand von Werkstück 1 und Ablöseschicht 10 zur Oberfläche der Metallplatte 22 eingestellt werden. Nach dem Aushärten des restlichen flüssigen PDMS sind somit Werkstück 1 und Ablöseschicht 10 auf der einen Seite mit der Stabilisierungsschicht 20, bestehend aus einem Laminat aus der Metallplatte 22 und zwei Schichten PDMS 24, 26, sowie auf der anderen Seite mit der Aufnahmeschicht 8, bestehend aus einer Schicht PDMS, verbunden. Die Dicke der Stabilisierungsschicht 20 kann durch geeignete Wahl der Dicke der Metallplatte 22, der ersten Menge flüssigen PDMS 24 sowie des Bodenabstands vorgegeben werden. Die Dicke der Aufnahmeschicht 8 kann durch geeignete Wahl des Bodenabstands sowie der zweiten Menge flüssigen PDMS vorgegeben werden. Ein separates Verkleben der Schichten ist in diesem Ausführungsbeispiel bevorzugt nicht nötig.

Diese Ausführungsform ist vorteilhaft, da die Dicken der jeweiligen Schichten derart einstellbar sind, dass das Werkstück 1 und die Ablöseschicht 10 in geeigneter Weise mit der Aufnahmeschicht 8 und der Stabilisierungsschicht 20 koppelbar bzw. wirkverbindbar sind.

Weiterhin kann z.B. durch Einpassen von vorzugsweise dünnen mechanischen Abstandshaltern 34, die vorzugsweise selbst aus PDMS bestehen können, der Abstand zwischen dem Werkstück 1 bzw. der Ablöseschicht 10 und der ersten festen PDMS-Schicht 24 vergrößert werden.

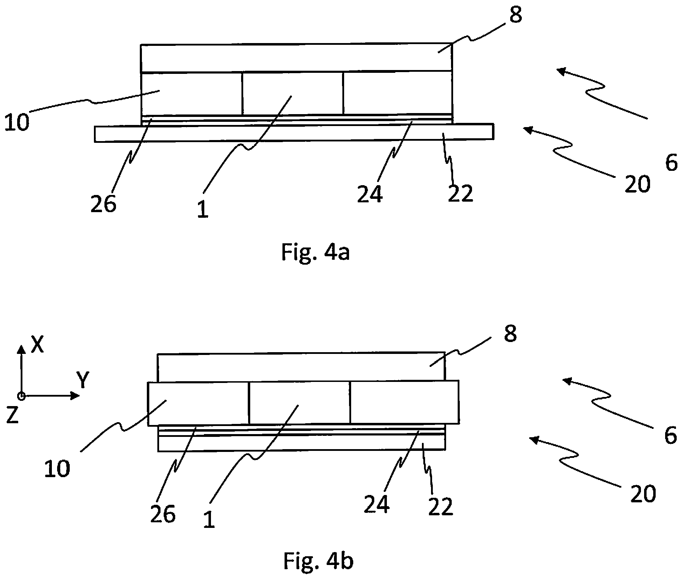

Fig. 4a zeigt, dass nach dem vollständigen Aushärten aller Polymer-Schichten und etwaigen Polymer-Klebeverbindungen gemäß einer bevorzugten Ausführungsform der vorliegenden Erfindung die seitlichen Ränder der Polymerschichten 8, 24, 26 in einem definierten Abstand zum Rand des Werkstücks 1 bzw. zum Rand der Ablöseschicht 10 zugeschnitten werden. Beispielsweise werden in einem Ausführungsbeispiel die Folienränder bündig zum Rand des Werkstücks 1 oder bündig zum Rand der Ablöseschicht 10 getrimmt. Beispielsweise werden in einem anderen Ausführungsbeispiel, worin wie weiter oben beschrieben als Werkstück 1 bevorzugt ein 4-inch, runder Germaniumwafer und als Ablöseschicht 10 bevorzugt ein aus einem 6-inch pseudoquadratischen Siliziumwafer geschnittener Siliziumrahmen verwendet wird, der Rand der Aufnahmeschicht 8 sowie der Rand der PDMS-Folie 24, 26 in der Stabilisierungsschicht 20 bevorzugt im Wesentlichen bündig zum äußeren Rand des Rahmens bzw. des Siliziumrahmens getrimmt.

In Fig. 4b sind die einzelnen Schichten 22, 24, 26, 8 im Wesentlichen oder genau mit den gleichen Abmessungen ausgebildet. Es ist hierbei auch denkbar, dass sich einzelne oder alle Schichten 22, 24, 26, 8 in der Y-Z-Ebene weniger weit erstrecken als die Ablöseschicht 10 und/oder das Werkstück 1.

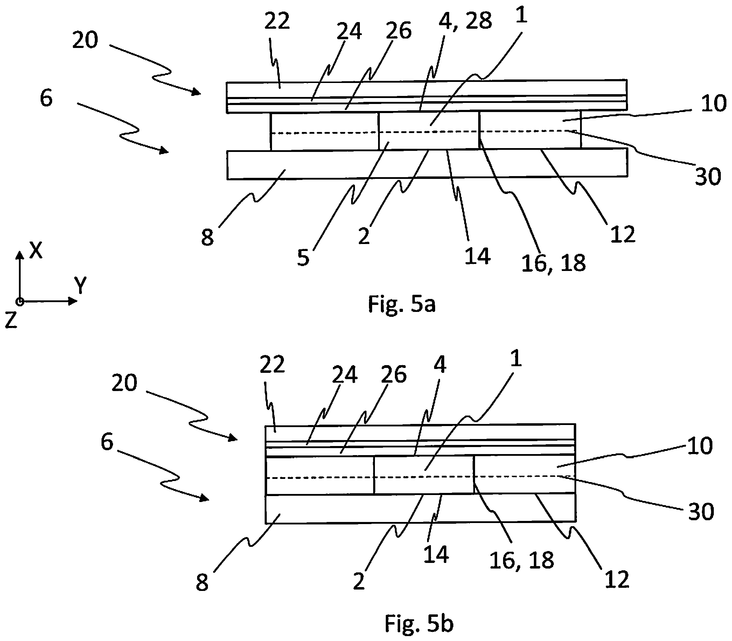

In Fig. 5a wird die Stabilisierungsschicht 20 durch die Metallschicht 22, die erste Polymerschicht 24 und die zweite Polymerschicht 26 gebildet. Die Stabilisierungsschicht 20 erstreckt sich dabei in der Y-Z-Ebene weitere als die Ablöseschicht 10 und/oder das Werkstück 1. Weiterhin überlagert die Aufnahmeschicht 8 zumindest abschnittsweise die Ablöseschicht 10, wobei die Ablöseschicht 10 bevorzugt zumindest abschnittsweise eine oder mehrere erste Grenzflächen 12 mit der Aufnahmeschicht 8 bildet. Die Aufnahmeschicht 8 ist mit der exponierten Oberfläche 2 des Werkstücks 1 unter Bildung einer Kompositstruktur bzw. eines Laminats verbunden, wobei die Aufnahmeschicht 8 zumindest abschnittsweise eine zweite Grenzfläche 14 mit der exponierten Oberfläche des Werkstücks 1 bildet, wobei diese zweite Grenzfläche 14 bevorzugt durch einen Rand 18 begrenzt wird, welcher zumindest abschnittsweise im Wesentlichen an einen Rand 16 einer oder mindestens einer der mehreren ersten Grenzflächen 12 angrenzt, und wobei die eine oder mindestens eine der mehreren ersten Grenzflächen 12 und die zweite Grenzfläche 14 zumindest abschnittsweise im Wesentlichen zueinander parallel ausgerichtet sind. Das Bezugszeichen 48 kennzeichnet eine bevorzugte Rissebene.

In Fig. 5b sind die einzelnen Schichten 22, 24, 26, 8 auf die Erstreckungsfläche der Ablöseschicht 10 und/oder des Werkstücks 1 getrimmt.

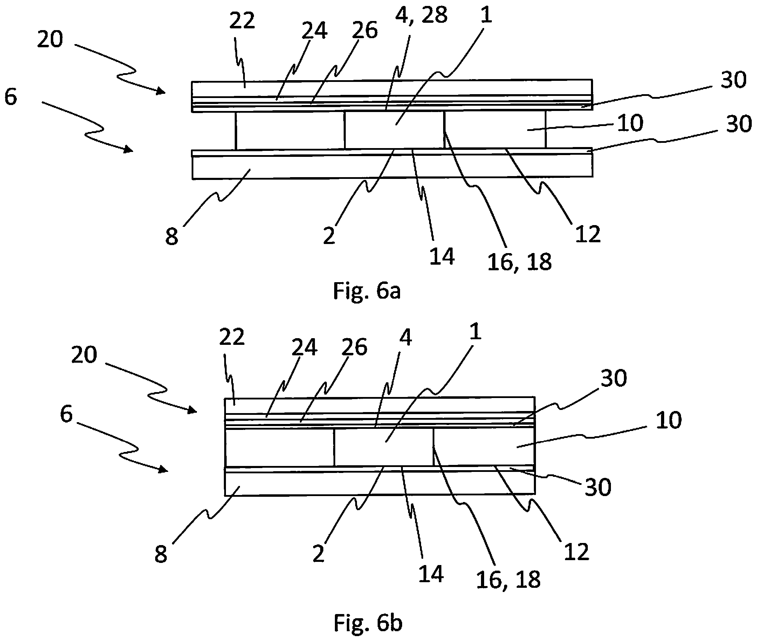

Gemäß der in Fig. 6a gezeigten Ausführungsform werden zwischen jeweils zwei im Rahmen von anderen hier beschriebenen Ausführungsformen miteinander verbundenen Schichten eine oder mehrere Zwischenschichten 30 eingefügt, welche beispielsweise die Haftung zwischen den beiden verbundenen Schichten erhöhen oder ein späteres Ablösen der beiden Schichten voneinander erleichtern. Beispielsweise wird in einer bevorzugten Ausführungsform zwischen der ersten bzw. der zweiten exponierten Oberfläche des Werkstücks 1 und der Aufnahmeschicht 8 bzw. der Stabilisierungsschicht 20 eine Opferschicht 30, welche beispielsweise ein Sol-Gel aufweist bzw. daraus besteht, eingefügt, welche ein späteres Ablösen der Aufnahmeschicht 8 bzw. der Stabilisierungsschicht 20 von der abgelösten Festkörperschicht 5 erleichtert. Beispielsweise wird in einer weiteren bevorzugten Ausführungsform zwischen der Aufnahmeschicht 8 und der Ablöseschicht 10 eine Haftschicht 30 eingefügt, mit welcher die Haftung zwischen der Aufnahmeschicht 8 und der Ablöseschicht 10 reproduzierbar eingestellt werden kann.

In Fig. 6b sind die einzelnen Schichten 22, 24, 26, 8 auf die Erstreckungsfläche der Ablöseschicht 10 und/oder des Werkstücks 1 getrimmt.

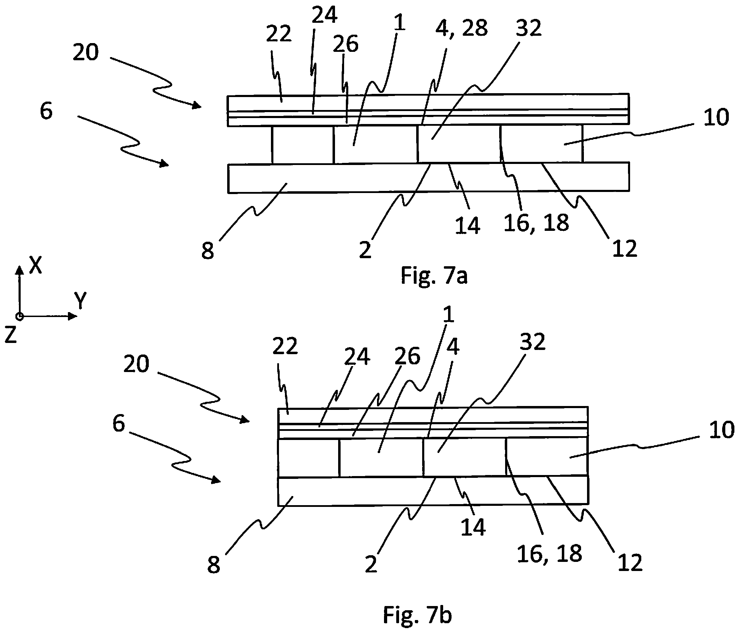

In Fig. 7a ist eine Ausführungsform gezeigt, gemäß der die Ablöseschicht 10 mehrere Werkstücke 1 und 32 zumindest abschnittsweise in der Umfangsrichtung umschließt. Die Werkstücke 1 und 32 können dabei aneinander anliegen oder zueinander beabstandet angeordnet sein. Bevorzugt sind die Werkstücke 1 und 32 weniger als 20 mm und bevorzugt weniger als 10 mm und besonders bevorzugt weniger als 2 mm voneinander beabstandet. Es ist hierbei denkbar, dass die Ablöseschicht 10 durch die einzelnen Werkstücke 1 und 32 ausgebildet wird, wobei besonders bevorzugt mehr als zwei, insbesondere mehr als 3 oder genau 3, oder mehr als 4 oder genau 4 oder mehr als 5 oder genau fünf Werkstücke 1, 32 vorgesehen sind. Die

In Fig. 7b sind die einzelnen Schichten 22, 24, 26, 8 auf die Erstreckungsfläche der Ablöseschicht 10 und/oder der Werkstücke 1 und 32 getrimmt.

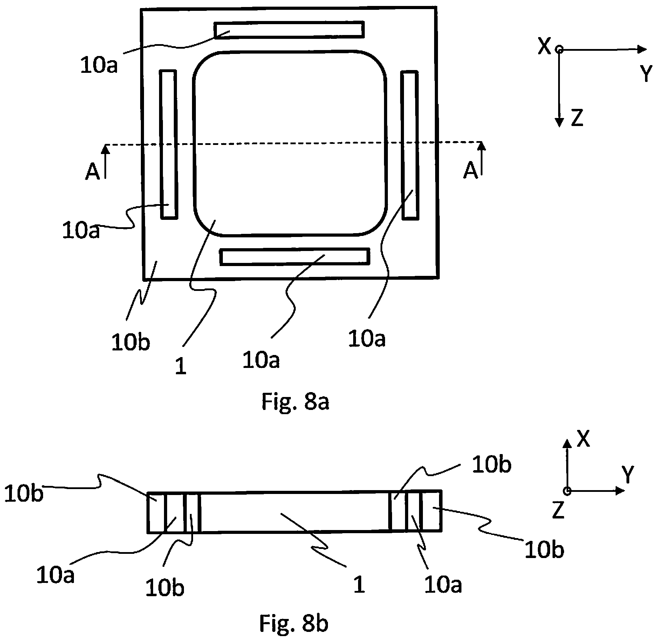

In Fig. 8a ist eine Ablöseschicht 10 gezeigt, die mehrere erste Anteile 10a aufweist, die bevorzugt als Opferwafer ausgebildet sind, und die mehrere zweite Anteile 10b aufweist, die bevorzugt aus einem anderen Material als die ersten Anteile 10a bestehen. Die zweiten Anteile 10b können dabei z.B. aus Papier, Karton, einem Polymerwerkstoff, wie PDMS, oder aus einem Substrat bestehen. Es ist hierbei denkbar, dass mehrere ersten Anteile 10a vorgesehen sind, wobei die sich in der Y-Z-Ebene ergebende Formen der einzelnen ersten Anteile 10a gleich oder verschieden sein können. Bevorzugt ist die Form der zweiten Anteile 10b jedoch von der sich in der Y-Z-Ebene ergebenden Form des Werkstücks verschieden.

Durch den Buchstaben A ist ein Schnitt in der X-Y-Ebene gekennzeichnet. Die sich durch den Schnitt A ergebende Schnittfläche ist in Fig. 8b gezeigt. Es ist dieser Darstellung zu entnehmen, dass das Werkstück 1 und die ersten und zweiten Anteile 10a und 10b der Ablöseschicht 10 bevorzugt im Wesentlichen bzw. genau dieselbe Ausdehnung in Z-Richtung bzw. Dicke aufweisen. Es ist jedoch ebenfalls vorstellbar, dass die Dicke des Werkstücks 1 und die Dicke der die Ablöseschicht 10 bildenden Anteile 10a, 10b voneinander abweicht bzw. zumindest stellenweise voneinander abweicht.

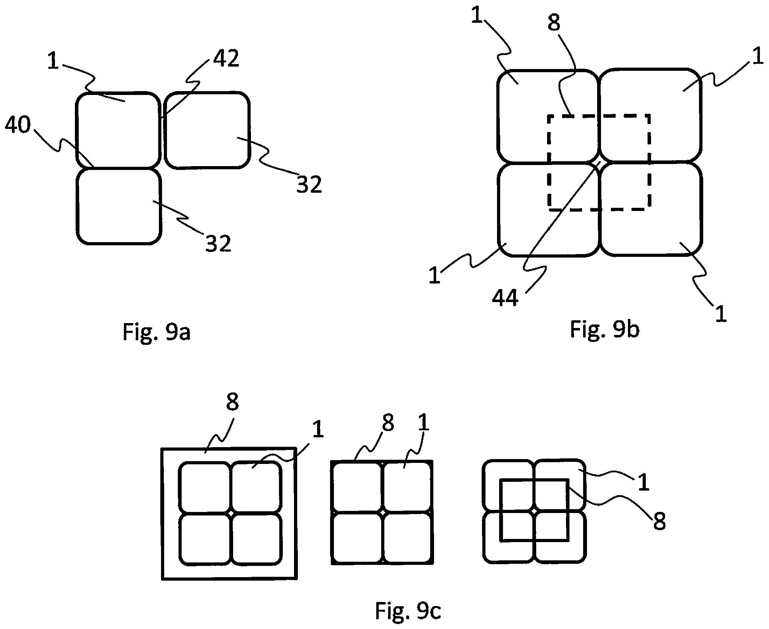

In Fig. 9a ist eine Beispiel gezeigt, gemäß dem verschiedene Anordnungsvarianten verdeutlicht werden. Es ist gemäß dieser Darstellung nämlich möglich, dass zwischen zwei oder mehreren Werkstücken 1 ein gewisser Abstand, insbesondere von weniger als 15 mm und bevorzugt von weniger als 5mm, vorgesehen ist. Das Bezugszeichen 42 kennzeichnet hierbei den Abstand zwischen den Werkstücken 1 und 32. Zusätzlich oder alternativ ist jedoch ebenfalls denkbar, dass einzelne oder alle Werkstücke 1, 32 unmittelbar aneinander anliegen können. Das Bezugszeichen 40 kennzeichnet daher eine bündige Anordnung.

Fig. 9b zeigt vier bevorzugte Werkstücke 1, insbesondere 6-inch pseudoquadratische monokristalline Siliziumwafer, in einer quadratischen Anordnung nebeneinander gelegt, so dass die Wafer 1 mit einer Seite alle in einer Ebene liegen und jeder Wafer jeweils zwei andere an den Kanten berührt. Durch die gesamte Anordnung, d.h. entlang einer Ebene parallel zur Waferebene und im Innern der Wafer, wird ein Bruch geführt, so dass sich eine Schicht mit einer entsprechenden quadratischen Anordnung von dünneren Schichten bzw. Wafern ablöste. Dabei zeigte sich, dass die größten Dickenschwankungen der abgelösten Schichten auf die Außenränder der gesamten Anordnung beschränkt bleiben, während in den Bereichen im Innern der Anordnung, auch dort, wo die einzelnen Wafer einander berührten, nur relativ geringe Dickenschwankungen auftreten.

Die Werkstücke 1 werden bevorzugt zunächst vorgekühlt und dann gesplittet. Durch das Bezugszeichen 44 ist ein Bereich angegeben, in dem Wafermaterial ausgespart ist, um die sich in diesem Bereich im Wafermaterial erwartbaren hohen Dickenschwankungen zu vermeiden. Die Werkstücke 1 sind gemäß dieser Anordnung auf einem Chuck (nicht gezeigt) angeordnet und mit einer untermassigen Polymerschicht, insbesondere PDMS, verbunden.

In Fig. 9c sind drei mögliche Anordnungen von mehreren Wafern gezeigt. In den dargestellten Ausführungsbeispielen werden jeweils vier Werkstücke 1 gezeigt, wobei die Anzahl beliebig sein kann. Bevorzugt sind mindestens oder genau zwei, mindestens oder genau drei, mindestens oder genau vier, mindestens oder genau fünf, oder mehr Werkstücke 1 gemäß den gezeigten Anordnungen anordenbar.

Gemäß der linken Darstellung ist die Polymerschicht 8, insbesondere eine PDMS-Schicht, übermassig ausgebildet. In der mittigen Darstellung ist die Polymerschicht 8, insbesondere eine PDMS-Schicht, gleichmassig ausgebildet und in der rechten Darstellung ist die Polymerschicht 8, insbesondere eine PDMS-Schicht, untermassig ausgebildet.

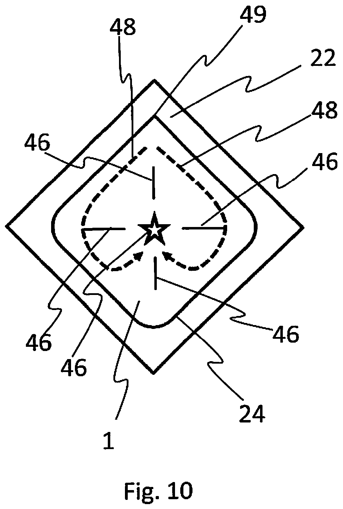

In Fig. 10 ist eine Metallplatte 22, eine auf der Metallplatte 22 angeordnete Polymerschicht 24 und ein auf der Polymerschicht 24 angeordnetes Werkstück 1 gezeigt. Die Polymerschicht 24 ist als Polymerschichtquadrat bzw. als PDMS-Quadrat ausgebildet. Weiterhin werden durch die Bezugszeichen 46 die Stellen der höchsten Dickenschwankungen angezeigt und durch das Bezugszeichen 48 werden Rissverläufe innerhalb des Werkstücks 1 benannt. Weiterhin kennzeichnet das Bezugszeichen 49 eine gegenüber den anderen Ecken spitzere Ecke bzw. eine Ecke mit einem gegenüber den anderen Ecken geringeren Radius. Die spitze Ecke stellt dabei eine Stelle dar von der ausgehend aufgrund der geometrischen Unterschiede zu den anderen Ecken eine Rissausbreitung wiederholbar bewirkt werden kann.

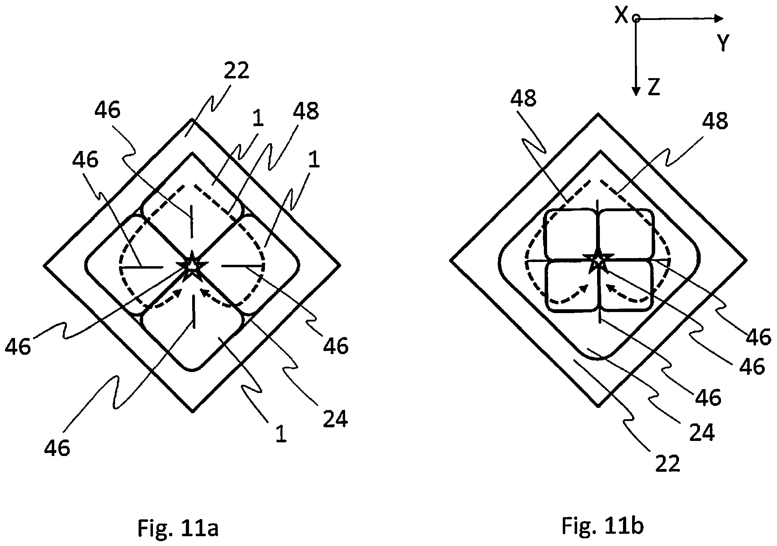

In Fig. 11a ist eine Anordnung von vier Werkstücken 1 gezeigt. Die Werkstücke 1 sind über eine erste Polymerschicht 24 mit einer Metallplatte 22 verbunden. Die Bezugszeichen 46 kennzeichnen in dieser Darstellung Bereiche, in denen beim Abspalten von Festkörperschichten von den Werkstücken 1 die größten Dickenschwankungen erwartet werden. Das Bezugszeichen 48 kennzeichnet den bei der gezeigten Anordnung typischen Rissverlauf. Aufgrund der äußeren Form der Werkstücke 1 ist erkennbar, dass die Gesamtheit der Werkstücke 1 ein Rechteck bzw. ein Quadrat ausbilden, in dessen Mitte sich eine Aussparung ausbildet. Die Aussparung liegt dabei genau in dem Bereich, in dem die höchsten Dickenschwankungen auftreten. Die höchsten Dickenschwankungen sind dabei durch einen schematischen "Stern" gekennzeichnet.

Das sich aus der Polymerschicht ergebende Polymerschichtquadrat bzw. PDMS-Quadrat weist im dargestellten Beispiel bevorzugt in der Y-Z-Ebene im Wesentlichen die vierfache Fläche der sich in der Y-Z-Ebene erstreckenden Oberfläche eines Werkstücks 1 auf.

In Fig. 11b ist die Anordnung aus Werkstücken 1 gegenüber der in Fig. 11a gezeigten Anordnung versetzt angeordnet. Es ist dieser Darstellung zu entnehmen, dass durch den Versatz bzw. die Rotation der Werkstücke 1 die als Linien gekennzeichneten hohen Dickenschwankungen 46 in diesen Randbereichen der Werkstücke 1 auftreten, in denen die einzelnen Werkstücke 1 aneinander anliegen.

Das sich aus der Polymerschicht 24 ergebende Polymerschichtquadrat bzw. PDMS-Quadrat weist im dargestellten Beispiel bevorzugt in der Y-Z-Ebene im Wesentlichen eine Fläche auf, die größer als das Vierfache der sich in der Y-Z-Ebene erstreckenden Oberfläche des Werkstücks 1 ist.

Es lässt sich somit aus den Figuren 11a und 11b erkennen, dass durch gezieltes Anordnen der Wafergeometrien die Dickenschwankungen, insbesondere am Rand des Wafers, beeinflussbar, insbesondere reduzierbar, sind. Weiterhin erkennt man, dass durch gezieltes Weglassen von Wafermaterial (hier z.B. im Zentrum, i.a. Problemstelle beim sog. freien Split), Dickenschwankungen vermieden werden können.

Weiterhin wird durch das gezielte Anordnen der Wafergeometrien erreicht, dass die Bruchebenen verschiedener Wafer im Wesentlichen und bevorzugt genau dieselben sind, d.h. es kann ein sauberer Übergang der Bruchflächen trotz Störstellen erreicht werden. Als Störstellen können z.B. Dichtesprünge oder unterschiedliche Materialien angesehen werden, d.h., dass der erste Wafer und der zweite Wafer aus unterschiedlichen Materialien bestehen können. Ein oder mehrere Wafer kann/können z.B. als Opferwafer vorgesehen sein.

Weiterhin ist denkbar, dass durch die Anbringung mehrerer Werkstücke1 bzw. Wafer auf einem Chuck/Panel, einer Beschichtung der Werkstücke 1 mit einem Polymer, insbesondere PDMS, und anschließendem Splitten sowie nachfolgendem Weiterverarbeiten des Chucks/Panels eine Automatisierung der Herstellung von Festkörperschichten bewirkbar ist.

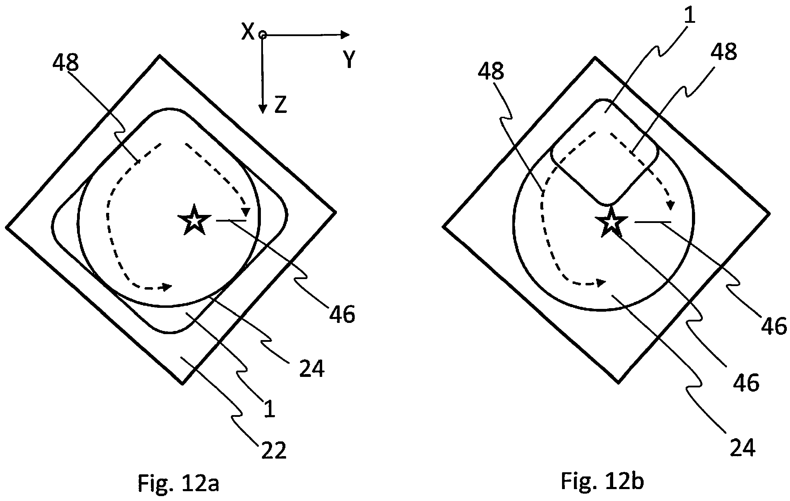

Gemäß der in Fig. 12a gezeigten Ausführungsform ist die Polymerschicht 24 tropfenförmig ausgebildet und weist in der Y-Z-Ebene eine Oberfläche auf, die bevorzugt kleiner als die Oberfläche des Werkstücks 1 ist.

In Fig. 12b ist eine Ausführungsform gezeigt, gemäß der die Polymerschicht 24 ebenfalls tropfenförmig ausgebildet ist und in der Y-Z-Ebene eine Oberfläche aufweist, die bevorzugt größer bzw. ein Vielfaches der sich in der Y-Z-Ebene erstreckenden Oberfläche des Werkstücks 1 beträgt. Das Werkstück 1 ist gegenüber der in Fig. 12a gezeigten Ausführungsform in der Y-Z-Ebene deutlich kleiner ausgebildet und/oder die Anordnung aus Metallplatte 22 und Polymerschicht 24 ist in der Y-Z-Ebene deutlich größer ausgebildet. Der sich dadurch ergebende Effekt ist, dass das Werkstück 1 in einem Bereich der Polymerschicht 24 anordenbar ist, der von den maximalen Dickenschwankungen 46 entfernt liegt, wodurch die abgespaltete Festkörperschicht vergleichsweise eine sehr homogene Dicke aufweist.

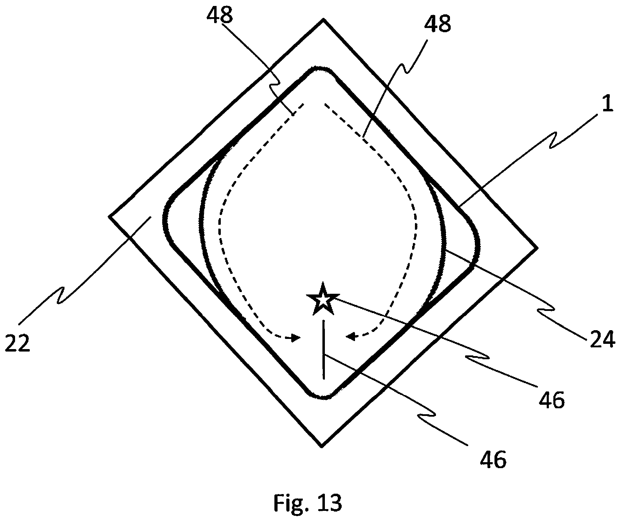

In Fig. 13 ist ein Werkstück 1 in einem Polymerschicht-Doppeltropfen 24 bzw. PDMS-Doppeltropfen dargestellt. Die sich in der Y-Z-Ebene erstreckende Oberfläche des Werkstücks 1 weist dabei bevorzugt eine pseudoquadratische Form auf.

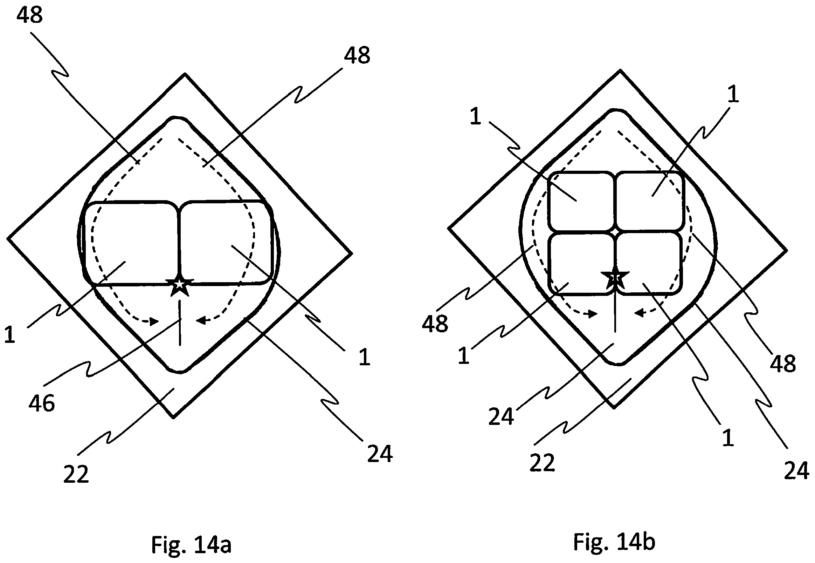

In den Figuren 14a und 14b sind jeweils mehrere Werkstücke 1 über die als Doppeltropfen ausgebildete Polymerschicht 24 mit der Metallschicht 22 verbunden. Es ist den Darstellungen entnehmbar, dass die Bereiche hoher Dickenschwankung 46 nur teilweise im Bereich der Werkstücke bzw. Wafer 1 liegen, wodurch die Qualität der einzelnen abgespalteten Schichten sehr hoch und homogen ist.

Die Werkstücke bzw. Wafer 1 können sich hierbei direkt kontaktieren oder abschnittsweise bzw. vollständig voneinander beabstandet angeordnet sein. Weiterhin ist denkbar, dass die Anzahl der im Doppeltropfen angeordneten Werkstücke 1 von der gezeigten Anzahl abweicht. Insbesondere können mehr als zwei oder genau zwei, mehr als drei oder genau drei, mehr als vier oder genau vier, oder mehr als fünf Werkstücke 1 mit der als Doppeltropfen ausgebildeten Polymerschicht 24 in Kontakt stehen.

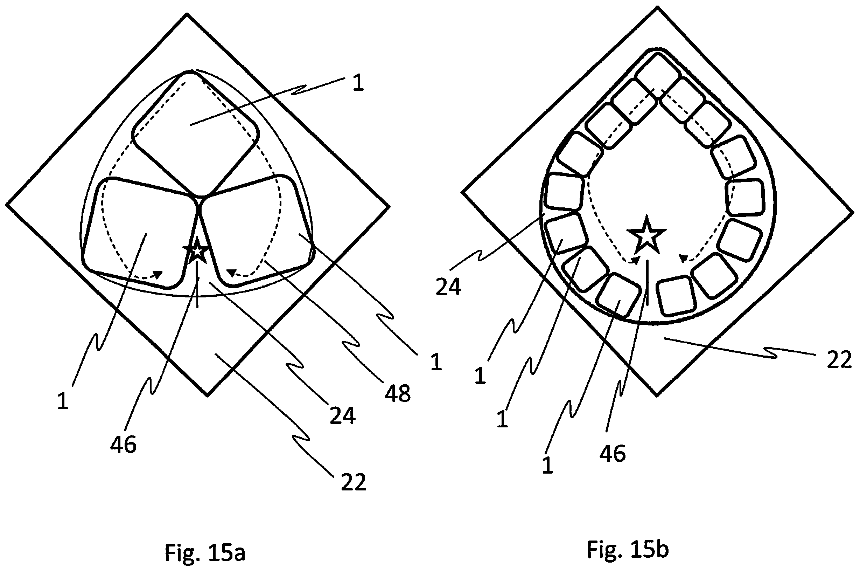

Die Figuren 15a und 15b zeigen weitere Anordnungen mehrerer Werkstücke und unterschiedlicher Polymerschichtformen. Es ist hierbei denkbar, dass die unterschiedlichen Polymerschichtformen jeweils mit einer unterschiedlichen Anzahl an Werkstücken 1 kombinierbar sind. In Fig. 15a ist die Polymerschicht 24 als Polymerschicht-Dreieck, insbesondere als PDMS-Dreieck, ausgebildet. Weiterhin kontaktieren sich gemäß der in Fig. 15a gezeigten Ausführungsform einzelne oder alle Werkstücke 1 in der Y-Z-Ebene nur punktförmig.

Gemäß der durch die Fig. 15b rein schematisch und exemplarisch gezeigten Ausführungsform können sich einzelne bzw. mehrere Werkstücke 1 in der Y-Z-Ebene punktuell berühren, einzelne bzw. mehrere Werkstücke 1 in Linienkontakt miteinander stehen oder einzelne bzw. mehrere Werkstücke 1 beabstandet zu ihrem nächsten Nachbarn angeordnet sein.

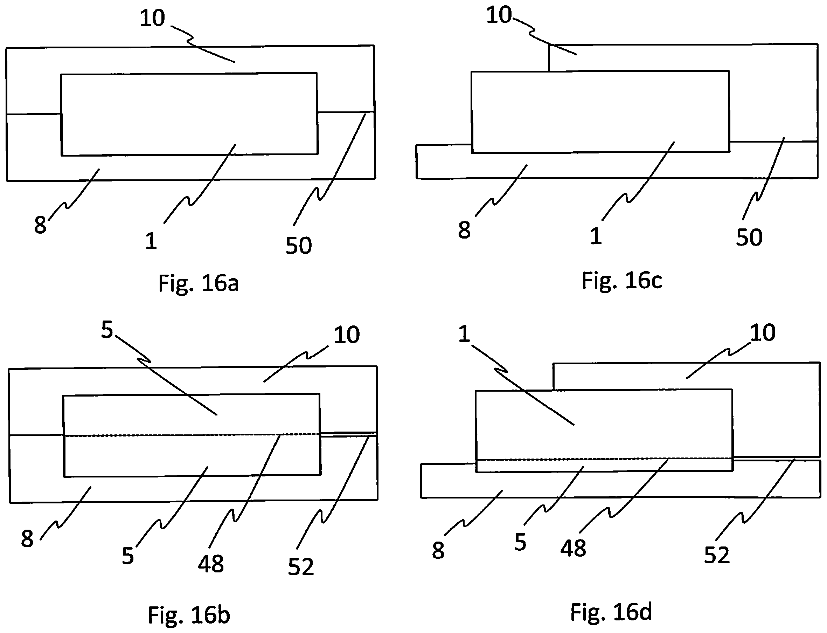

In Fig. 16a ist eine Ausführungsform gezeigt, gemäß der das Werkstück 1 einerseits von einer Aufnahmeschicht 8 und andererseits von einer Ablöseschicht 10 umgeben ist. Die Aufnahmeschicht 8 und die Ablöseschicht 10 stehen dabei erfindungsgemäß miteinander in Kontakt.

Die Kontaktfläche zwischen der Aufnahmeschicht 8 und der Ablöseschicht 10 wir hierbei als Interface 50 bezeichnet.

In Fig. 16b ist ein Zustand gezeigt, der nach der Einbringung von definierten Spannungen in die Aufnahmeschicht 8 und/oder in die Ablöseschicht 10 eintritt. Die Aufnahmeschicht 8 und die Ablöseschicht 10 lösen sich im Bereich des Interfaces 50 voneinander ab. Die Ablösung ist durch das Bezugszeichen 52 gekennzeichnet und schematisch als Beabstandung zwischen der Aufnahmeschicht 8 und der Ablöseschicht 10 dargestellt. Das Bezugszeichen 48 kennzeichnet hierbei den Rissverlauf innerhalb des Werkstücks 1, wobei sich der Riss 48 bevorzugt in derselben Ebene ausbreitet, in der auch die Kontaktfläche zwischen der Ablöseschicht 10 und der Aufnahmeschicht 8 ausgebildet ist. Der Riss verläuft gemäß dieser Darstellung auch derart, dass er das Werkstück 1 in zwei im Wesentlichen oder genau gleich dicke Festkörperschichten teilt.

In Fig. 16c ist eine Variante der in Fig. 16a gezeigten Ausführungsform dargestellt. Die in Fig. 16c gezeigte Anordnung zeigt eine Ablöseschicht 10, die das Werkstück 8 nicht vollständig umschließt, sondern nur abschnittsweise das Werkstück 1 überlagert. Ferner ist das Werkstück 1 nur mit einem Teil seiner Dicke, der weniger als die Hälfte seiner Gesamtdicke beträgt, von der Aufnahmeschicht 8 umschlossen.

In Fig. 16d ist analog zur Fig. 16b ein Zustand gezeigt, in dem infolge einer Spannungserzeugung eine Ablösung der Aufnahmeschicht 8 von der Ablöseschicht 10 erfolgt ist. Weiterhin breitet sich der Riss gemäß der Fig. 16b und gemäß der Fig. 16d bevorzugt infolge der Ablösung in das Werkstück 1 aus.

Es ist hierbei ebenfalls denkbar, dass die Ausführungsformen der Figuren 16a-d miteinander kombiniert werden können. D.h. zum Beispiel, dass die Ablöseschicht 10 das Werkstück 1 in Fig. 16a nur teilweise überlagert oder dass das Werkstück 1 in Fig. 16a entsprechend der Fig. 16c von der Aufnahmeschicht 8 umgeben ist.

Ferner gilt für alle Ausführungsbeispiele, dass die Ablöseschicht eine Dicke aufweisen kann, die bevorzugt der Dicke des Wafers entspricht. Es ist jedoch ebenfalls vorstellbar, dass die Ablöseschicht eine Dicke aufweist, die größer oder geringer ist als die Dicke des Wafers. Weiterhin gilt für alle Ausführungsbeispiele, dass die Ablöseschicht eine Dicke aufweisen kann, die bevorzugt der Dicke der Aufnahmeschicht entspricht. Es ist jedoch ebenfalls vorstellbar, dass die Ablöseschicht eine Dicke aufweist, die größer oder geringer ist als die Dicke der Aufnahmeschicht. Weiterhin gilt für alle Ausführungsbeispiele, dass die Ablöseschicht eine Dicke aufweisen kann, die bevorzugt der Dicke der Stabilisierungsschicht entspricht. Es ist jedoch ebenfalls vorstellbar, dass die Ablöseschicht eine Dicke aufweist, die größer oder geringer ist als die Dicke der Stabilisierungsschicht.

### Bezugszeichenliste

1. Werkstück
2. Exponierte Oberfläche
4. Weitere exponierte Oberfläche
5. Festkörperschicht
6. Trägereinheit
8. Aufnahmeschicht
10. Ablöseschicht
12. Erste Grenzfläche
14. Zweite Grenzfläche
16. Rand, der die erste Grenzfläche begrenzt
18. Rand, der die zweite Grenzfläche begrenzt
20. Stabilisierungsschicht
22. Metallschicht
24. Erste Polymerschicht
26. Zweite Polymerschicht
28. Dritte Grenzfläche
30. Zwischenschicht
32. Weiteres Werkstück
34. Abstandshalter
36. Überstehender Anteil
38. Verbindungsstelle
40. Bündige Anordnung
42. Beabstandete Anordnung
44. Aussparung
46. Zone hohen TTV's
48. Rissverlauf
49. Rissauslösestelle
50. Interface
52. Ablösung
A Schnitt
X erste Richtung
Y zweite Richtung
Z dritte Richtung

## Patentansprüche

1. Verfahren zur Herstellung von Festkörperschichten (5), insbesondere zur Verwendung als Wafer, mit den folgenden Schritten:
Bereitstellen mindestens eines Werkstücks (1) zum Ablösen der Festkörperschichten (5),
wobei das Werkstück (1) zumindest eine exponierte Oberfläche aufweist,
Erzeugen und/oder Bereitstellen einer Trägereinheit (6) zum Aufnehmen mindestens einer Festkörperschicht (5),
wobei die Trägereinheit (6) zumindest eine Aufnahmeschicht (8) zum Halten der Festkörperschicht (5) aufweist, die zumindest abschnittweise von einer Ablöseschicht (10) überlagert wird,
zumindest abschnittsweises Verbinden der Aufnahmeschicht (8) mit der exponierten Oberfläche (2) des Werkstücks (1) unter Bildung einer Kompositstruktur, wobei die Ablöseschicht (10) das Werkstück (1) zumindest abschnittsweise in Umfangsrichtung umschließt und wobei die Aufnahmeschicht (8) und die Ablöseschicht (10) miteinander in Kontakt stehen,
Beaufschlagen der Kompositstruktur mit einem inneren und/oder äußeren Spannungsfeld in der Art, dass die Festkörperschicht (5) entlang einer sich innerhalb des Werkstücks (1) erstreckenden Ebene durch eine Rissausbreitung (48) von dem Werkstück (1) abgelöst wird, wobei der Riss (48) sich zunächst im Bereich der Ablöseschicht (10) ausbreitet und mittels der Ablöseschicht (10) in das Werkstück (1) eingeleitet wird,
**dadurch gekennzeichnet, dass**
sich bei der Beaufschlagung der Kompositstruktur mit dem Spannungsfeld der Riss (48) zum Ablösen der Festkörperschicht zunächst innerhalb der Ablöseschicht (10) derart ausbreitet, dass ein Teil der Ablöseschicht (10) abgespalten wird, wobei die Ablöseschicht (10) derart in Umfangsrichtung des Werkstücks (1) ausgebildet wird, insbesondere in einem Abstand von weniger als 10 mm bevorzugt von weniger als 5 mm und besonders bevorzugt von weniger als 2 mm zu dem Werkstück (1), dass der Rissverlauf (48) in der Ablöseschicht (10) und in dem Werkstück (1) in derselben Ebene liegt.

2. Verfahren zur Herstellung von Festkörperschichten (5) nach Anspruch 1,
**dadurch gekennzeichnet, dass**
durch die Ablöseschicht (10) ein Rahmen ausgebildet wird, der das Werkstück (1) zumindest in Umfangsrichtung vollständig umschließt.

3. Verfahren zur Herstellung von Festkörperschichten (5) nach einem der vorangegangenen Ansprüche,
**dadurch gekennzeichnet, dass**
die Ablöseschicht (10) durch mindestens ein weiteres Werkstück (1, 32) ausgebildet wird, wobei infolge der Beaufschlagung der Kompositstruktur mit dem Spannungsfeld von jedem Werkstück (1,32) eine Festkörperschicht (5) abgelöst wird.

4. Verfahren zur Herstellung von Festkörperschichten (5) nach einem der vorangegangenen Ansprüche,
**dadurch gekennzeichnet, dass**
das Werkstück (1) von einem Bereich der Ablöseschicht (10) umschlossen wird, in dem sich eine durch den Riss (48) ergebende Dickenschwankung geringer ist als in mindestens einem anderen Bereich der Ablöseschicht (10).

5. Verfahren zur Herstellung von Festkörperschichten (5) nach einem der vorangegangenen Ansprüche,
**dadurch gekennzeichnet, dass**
das axiale Zentrum des Werkstücks (1) und das axiale Zentrum der Ablöseschicht (10) voneinander beabstandet angeordnet werden.

6. Verfahren zur Herstellung von Festkörperschichten (5) nach einem der vorangegangenen Ansprüche,
**dadurch gekennzeichnet, dass**
eine durch den Umfang der Ablöseschicht (10) beschriebene erste Grundform von einer durch den Umfang des Werkstücks (1) beschriebenen zweiten Grundform abweicht, bevorzugt ist eine der Grundformen abschnittsweise gebogen und die von dem Umfang der Ablöseschicht (10) beschriebene Grundform ist zumindest abschnittsweise geradlinig.

7. Verfahren zur Herstellung von Festkörperschichten (5) nach einem der vorangegangenen Ansprüche,
**dadurch gekennzeichnet, dass**
die Ablöseschicht (10) durch einen Wafer gebildet wird, wobei der Wafer bevorzugt Silizium oder Germanium aufweist.

8. Verfahren zur Herstellung von Festkörperschichten (5) nach einem der vorangegangenen Ansprüche,
**dadurch gekennzeichnet, dass**
die Ablöseschicht (10) ein Polymer, insbesondere PDMS, aufweist und die Aufnahmeschicht (8) ein Metall, insbesondere Aluminium und/oder ein Polymer aufweist.

9. Wafer hergestellt nach einem Verfahren gemäß einem der Ansprüche 1-8.

10. Vorrichtung zur Herstellung von Festkörperschichten (5), insbesondere Wafern, mindestens umfassend
eine Einrichtung zum Induzieren von definierten lokalen Spannungen in eine Kompositstruktur zum Abspalten einer Festkörperschicht (5) von einem Werkstück (1),
wobei die Einrichtung eine Aufnahmeschicht (8) aufweist, die eine im Wesentlichen ebene Oberfläche zum Aufnehmen des Werkstucks (1) ausbildet und wobei ein Spannungsinduzierungsmittel derart angeordnet ist, dass es mit der Aufnahmeschicht (8) zusammenwirkt,
wobei die Oberfläche zum Aufnehmen des Werkstücks (1) größer ist als die Werkstückoberfläche, die damit koppelbar ist, und
wobei auf der Oberfläche zum Aufnehmen des Werkstücks eine Ablöseschicht (10) aufbringbar ist, die das Werkstück (1) in Umfangsrichtung zumindest teilweise umschließt,
**dadurch gekennzeichnet, dass**
durch die Spannungsinduziermittel ein Riss in der Ablöseschicht (8) erzeugbar ist, der auf das Werkstück (1) übergeht, wobei die Ablöseschicht (10) derart in Umfangsrichtung des Werkstücks (1) ausgebildet wird, insbesondere in einem Abstand von weniger als 10 mm bevorzugt von weniger als 5 mm und besonders bevorzugt von weniger als 2 mm zu dem Werkstück (1), dass der Rissverlauf (48) in der Ablöseschicht (10) und in dem Werkstück (1) in derselben Ebene liegt.

## Claims

1. Method for producing solid-state layers (5), in particular for use as wafers, having the following steps:
providing at least one workpiece (1) for detaching the solid-state layers (5),
wherein the workpiece (1) has at least one exposed surface,
generating and/or providing a carrier unit (6) for receiving at least one solid-state layer (5),
wherein the carrier unit (6) has at least one receiving layer (8) for holding the solid-state layer (5), a detachment layer (10) being superimposed at least in certain portions on said receiving layer,
connecting the receiving layer (8) at least in certain portions to the exposed surface (2) of the workpiece (1), to form a composite structure, wherein the detachment layer (10) surrounds the workpiece (1) at least in certain portions in a peripheral direction and wherein the receiving layer (8) and the detachment layer (10) are in contact with one another,
subjecting the composite structure to an internal and/or external stress field in such a way that the solid-state layer (5) is detached from the workpiece (1) along a plane extending within the workpiece (1), by crack propagation (48), wherein the crack (48) initially propagates in the region of the detachment layer (10) and is introduced into the workpiece (1) by means of the detachment layer (10),
**characterized in that**,
when the composite structure is subjected to the stress field, the crack (48) for detachment of the solid-state layer initially propagates within the detachment layer (10) in such a way that a part of the detachment layer (10) is separated off, wherein, in the peripheral direction of the workpiece (1), the detachment layer (10) is configured in such a way, in particular at a distance of less than 10 mm, preferably of less than 5 mm, and particularly preferably of less than 2 mm, from the workpiece (1), that the crack profile (48) in the detachment layer (10) and in the workpiece (1) lies in the same plane.

2. Method for producing solid-state layers (5) according to Claim 1,
**characterized in that**
the detachment layer (10) forms a frame which completely surrounds the workpiece (1) at least in the peripheral direction.

3. Method for producing solid-state layers (5) according to either of the preceding claims,
**characterized in that**
the detachment layer (10) is formed by at least one further workpiece (1, 32), wherein, as a result of the composite structure being subjected to the stress field, a solid-state layer (5) is detached from each workpiece (1, 32).

4. Method for producing solid-state layers (5) according to one of the preceding claims,
**characterized in that**
the workpiece (1) is surrounded by a region of the detachment layer (10), in which region a thickness variation produced as a result of the crack (48) is lower than in at least one other region of the detachment layer (10) .

5. Method for producing solid-state layers (5) according to one of the preceding claims,
**characterized in that**
the axial centre of the workpiece (1) and the axial centre of the detachment layer (10) are arranged so as to be spaced apart from one another.

6. Method for producing solid-state layers (5) according to one of the preceding claims,
**characterized in that**
a first basic shape, which is described by the periphery of the detachment layer (10), deviates from a second basic shape, which is described by the periphery of the workpiece (1), preferably one of the basic shapes is bent in certain portions and the basic shape described by the periphery of the detachment layer (10) is rectilinear at least in certain portions.

7. Method for producing solid-state layers (5) according to one of the preceding claims,
**characterized in that**
the detachment layer (10) is formed by a wafer, wherein the wafer preferably comprises silicon or germanium.

8. Method for producing solid-state layers (5) according to one of the preceding claims,
**characterized in that**
the detachment layer (10) comprises a polymer, in particular PDMS, and the receiving layer (8) comprises a metal, in particular aluminium, and/or a polymer.

9. Wafer produced by a method according to one of Claims 1-8.

10. Apparatus for producing solid-state layers (5), in particular wafers, at least comprising
a device for inducing defined local stresses in a composite structure in order to separate a solid-state layer (5) from a workpiece (1),
wherein the device has a receiving layer (8) which forms a substantially flat surface for receiving the workpiece (1), and wherein a stress-inducing means is arranged in such a way that it interacts with the receiving layer (8),
wherein the surface for receiving the workpiece (1) is larger than the workpiece surface that can be coupled thereto, and
wherein a detachment layer (10), which surrounds the workpiece (1) at least in certain portions in the peripheral direction, can be applied to the surface for receiving the workpiece,
**characterized in that**
the stress-inducing means is able to generate a crack in the detachment layer (8), said crack passing onto the workpiece (1), wherein, in the peripheral direction of the workpiece (1), the detachment layer (10) is configured in such a way, in particular at a distance of less than 10 mm, preferably of less than 5 mm, and particularly preferably of less than 2 mm, from the workpiece (1), that the crack profile (48) in the detachment layer (10) and in the workpiece (1) lies in the same plane.

## Revendications

1. Procédé de fabrication de couches (5) de semi-conducteur, à utiliser notamment comme tranche, comprenant les stades suivants :
on se procure au moins une pièce (1) pour le détachement des couches (5) de semi-conducteur,
la pièce (1) ayant au moins une surface à découvert,
on produit et/ou on se procure une unité (6) de support pour la réception d'au moins une couche (5) de semi-conducteur,
l'unité (6) de support ayant au moins une couche (8) de réception pour le maintien de la couche (5) de semi-conducteur, que l'on superpose au moins par endroit d'une couche (10) de détachement,
on relie, au moins par endroits, la couche (8) de réception à la surface (2) à découvert de la pièce (1) en formant une structure composite, la couche (10) de détachement en entourant la pièce (1), au moins par endroits, dans la direction du pourtour, et la couche (8) de réception et la couche (10) de détachement étant en contact entre elles,
on applique à la structure composite un champ de tensions intérieures et/ou extérieures de manière à détacher de la pièce (1), par une propagation (48) de fissure, la couche (5) de semi-conducteur le long d'un plan s'étendant au sein de la pièce (1), la fissure (48) se propageant d'abord dans la partie de la couche (10) de détachement et étant amorcée dans la pièce (1) au moyen de la couche (10) de détachement,
**caractérisé en ce que**,
lors de l'application du champ de tensions à la structure composite, la fissure (48) pour le détachement de la couche (5) de semi-conducteur se propage d'abord au sein de la couche (10) de détachement de manière à séparer une partie de la couche (10) de détachement, la couche (10) de détachement étant constituée dans la direction du pourtour de la pièce (1), notamment à une distance de moins de 10 mm, de préférence de moins de 5 mm et, d'une manière particulièrement préférée, de moins de 2 mm de la pièce (1) de manière à ce que le tracé (48) de la fissure dans la couche (10) de détachement et dans la pièce (1) soit dans le même plan.

2. Procédé de fabrication de couches (5) de semi-conducteur suivant la revendication 1,
**caractérisé en ce que**
on constitue par la couche (10) de détachement un cadre, qui entoure complètement la pièce (1) au moins dans la direction du pourtour.

3. Procédé de fabrication de couches (5) de semi-conducteur suivant l'une des revendications précédentes,
**caractérisé en ce que**
on constitue la couche (10) de détachement par au moins une autre pièce (1, 32), dans lequel, en raison de l'application du champ de tensions à la structure composite, on détache une couche (5) de semi-conducteur de chaque pièce (1, 32).

4. Procédé de fabrication de couches (5) de semi-conducteur suivant l'une des revendications précédentes,
**caractérisé en ce que**
on entoure la pièce (1) d'une partie de la couche (10) de détachement, dans laquelle une fluctuation d'épaisseur provenant de la fissure (48) est plus petite que dans au moins une autre partie de la couche (10) de détachement.

5. Procédé de fabrication de couches (5) de semi-conducteur suivant l'une des revendications précédentes,
**caractérisé en ce que**
on met le centre axial de la pièce (1) et le centre axial de la couche (10) de détachement à distance l'un de l'autre.

6. Procédé de fabrication de couches (5) de semi-conducteur suivant l'une des revendications précédentes,
**caractérisé en ce que**
une première forme de base, décrite par le pourtour de la couche (10) de détachement, s'écarte d'une deuxième forme de base, décrite par le pourtour de la pièce (1), de préférence l'une des formes de base est incurvée au moins par endroit et l'autre forme de base, décrite par le pourtour de la couche (10) de détachement, est rectiligne au moins par endroits.

7. Procédé de fabrication de couches (5) de semi-conducteur suivant l'une des revendications précédentes,
**caractérisé en ce que**
on forme la couche (10) de détachement par une tranche, la tranche ayant de préférence du silicium ou du germanium.

8. Procédé de fabrication de couches (5) de semi-conducteur suivant l'une des revendications précédentes,
**caractérisé en ce que**
la couche (10) de détachement a un polymère, notamment du PDMS, et la couche (8) de réception un métal, notamment de l'aluminium, et/ou un polymère.

9. Tranche fabriquée par un procédé sur l'une des revendications 1 à 8.

10. Installation de fabrication de couches (5) de semi-conducteur, notamment des tranches, comprenant au moins
un dispositif pour l'induction de tensions locales définies dans une structure composite pour la séparation d'une couche (5) de semi-conducteur d'une pièce (1),
dans laquelle le dispositif a une couche (8) de réception, qui constitue une surface sensiblement plane pour la réception de la pièce 1 et dans lequel un moyen d'induction de tensions est disposé de manière à coopérer avec la couche (8) de réception,
dans laquelle la surface de réception de la pièce (1) est plus grande que la surface de la pièce, qui peut ainsi être jointe, et
dans laquelle, à la surface de réception de la pièce, peut être déposée une couche (10) de détachement qui entoure la pièce (1) au moins en partie dans la direction du pourtour, **caractérisée en ce que**
par le moyen d'induction de tensions peut être produit dans la couche (8) de détachement une fissure, qui se transmet à la pièce, la couche (8) de détachement étant constituée dans la direction du pourtour de la pièce (1), notamment à une distance de moins de 10 mm, de préférence de moins de 5 mm et, d'une manière particulièrement préférée, de moins de 2 mm de la pièce (1) de manière à ce que le tracé (48) de la fissure dans la couche (10) de détachement et dans la pièce (1) soit dans le même plan.
